# EUROPÄISCHE PATENTSCHRIFT

(11) **EP 2 791 919 B1**
(45) Veröffentlichungstag und Bekanntmachung des Hinweises auf die Patenterteilung: **18.05.2022**
(21) Anmeldenummer: 12805945.8
(22) Anmeldetag: 06.12.2012
(51) Int. Cl.: G07D 7/04

(54) **VERFAHREN UND VORRICHTUNG ZUR PRÜFUNG VON WERTDOKUMENTEN**
METHOD AND DEVICE FOR CHECKING VALUE DOCUMENTS
PROCÉDÉ ET DISPOSITIF DE CONTRÔLE DE DOCUMENTS DE VALEUR

(30) Priorität: 13.12.2011 DE 102011120972
(43) Veröffentlichungstag der Anmeldung: 22.10.2014
(73) Patentinhaber: Giesecke+Devrient Currency Technology GmbH, 81677 München (DE)
(72) Erfinder: SCHÜTZMANN, Jürgen, 85276 Pfaffenhofen (DE)
(74) Vertreter: Giesecke + Devrient IP
(86) Internationale Anmeldenummer: PCT/EP2012/005035
(87) Internationale Veröffentlichungsnummer: WO 2013/087168

(56) Entgegenhaltungen:
- EP-A1- 0 428 779
- WO-A1-2013/020702
- DE-A1-102004 049 999
- DE-A1-102008 061 507
- DE-A1-102009 039 588
- None

## Beschreibung

Die Erfindung betrifft ein Verfahren und eine Vorrichtung zur Prüfung von Wertdokumenten, wie z.B. Banknoten, Schecks, Karten, Tickets, Coupons.

Aus dem Stand der Technik ist es bekannt, Wertdokumente mit Sicherheitselementen, etwa Sicherheitsstreifen oder auch Sicherheitsfäden, auszustatten, die magnetisches Material enthalten. Das magnetische Material kann dabei entweder durchgehend oder nur bereichsweise, zum Beispiel in Form einer Kodierung auf das Sicherheitselement aufgebracht sein. Zur magnetischen Kodierung eines Sicherheitselements dient beispielsweise eine bestimmte Abfolge von magnetischen und nichtmagnetischen Bereichen, die für das Wertdokument charakteristisch ist. Außerdem ist es bekannt, verschiedene magnetische Materialien für eine Magnetkodierung zu verwenden, z.B. mit unterschiedlichen Koerzitivfeldstärken. Zum Beispiel werden zwei verschieden koerzitive magnetische Materialien eingesetzt, aus welchen zwei Sorten von Magnetbereichen gebildet werden, die auf dem Sicherheitselement angeordnet sind.

Ferner ist es bekannt, Banknoten mit Sicherheitsfäden, die eine Magnetkodierung aus verschieden koerzitiven Materialien aufweisen, maschinell zu prüfen. Dabei werden die Banknoten parallel zur Längsrichtung des Sicherheitselements transportiert und durchlaufen nacheinander zuerst ein starkes Magnetfeld parallel zur Transportrichtung, das sowohl die hoch- als auch die niederkoerzitiven Magnetbereiche entlang der Transportrichtung magnetisiert. Die verbleibende Magnetisierung wird mittels eines induktiven Magnetdetektors, der parallel zur Transportrichtung empfindlich ist, geprüft. Anschließend durchlaufen die Banknoten ein schwächeres Magnetfeld senkrecht zur Transportrichtung, das nur die niederkoerzitiven Magnetbereiche senkrecht zur Transportrichtung ausrichtet, während die hochkoerzitiven Magnetbereiche in Transportrichtung magnetisiert bleiben. Erneut wird die verbleibende Magnetisierung mittels eines induktiven Magnetdetektors, der parallel zur Transportrichtung empfindlich ist, geprüft. Mit dem ersten induktiven Magnetdetektor werden dabei die hoch- und die niederkoerzitiven Magnetbereiche detektiert und mit dem zweiten induktiven Magnetdetektor werden nur die hochkoerzitiven Magnetbereiche detektiert. Falls das Sicherheitselement jedoch auch kombinierte Magnetbereiche enthält, die beide verschieden koerzitiven Magnetmaterialien enthalten, so dass die verschieden koerzitiven Magnetmaterialien zugleich in den Detektionsbereich des Magnetdetektors gelangen, wird eine Überlagerung der Magnetsignale der verschieden koerzitiven Magnetmaterialien detektiert. Die kombinierten Magnetbereiche liefern dabei ein reduziertes Magnetsignal, dessen Signalhub zwischen dem der hochkoerzitiven und dem der niederkoerzitiven Magnetbereiche liegt. Nachteilig ist bei diesem Verfahren, dass diese kombinierten Magnetbereiche nur schwer von den hochkoerzitiven und von den niederkoerzitiven Magnetbereichen unterscheidbar sind. Desweiteren ist es nachteilig, für das Ummagnetisieren der niederkoerzitiven Magnetbereiche ein Magnetfeld zu verwenden, das parallel zur Transportebene und senkrecht zur Transportrichtung des Wertdokuments orientiert ist. Denn mit Hilfe üblicher Magnete lassen sich so orientierte Magnetfelder nur mit relativ geringer Magnetfeldstärke realisieren. Die Prüfung derartige Wertdokumente ist beispielsweise aus DE 10 2009 039 588 A1, DE 10 2008061 507 A1, EP 0 428 779 A1 und DE 10 2004 049 999 A1 bekannt.

Der Erfindung liegt daher die Aufgabe zugrunde, die Prüfung der Wertdokumente so durchzuführen, dass die verschiedenen Magnetbereiche eines Sicherheitselements jeweils zuverlässig voneinander unterschieden werden können.

Diese Aufgabe wird durch die Gegenstände der unabhängigen Ansprüche gelöst. In davon abhängigen Ansprüchen sind vorteilhafte Weiterbildungen und Ausgestaltungen der Erfindung angegeben.

Das zu prüfende Wertdokument weist ein Sicherheitselement mit mehreren Magnetbereichen auf. Zu den Magnetbereichen gehören mindestens ein hochkoerzitiver Magnetbereich aus einem hochkoerzitiven Magnetmaterial mit einer ersten Koerzitivfeldstärke, gegebenenfalls mindestens ein niederkoerzitiver Magnetbereich aus einem niederkoerzitiven Magnetmaterial mit einer zweiten Koerzitivfeldstärke, die geringer ist als die erste Koerzitivfeldstärke, und gegebenenfalls mindestens ein kombinierter Magnetbereich, der sowohl das hochkoerzitive als auch das niederkoerzitive Magnetmaterial aufweist. Das hochkoerzitive und das niederkoerzitive Magnetmaterial des kombinierten Magnetbereichs sind z.B. aufeinander angeordnet oder in diesem in Form einer Mischung enthalten. Ferner kann das Sicherheitselement auch einen oder mehrere weichmagnetische Magnetbereiche aufweisen.

Vorzugsweise ist der mindestens eine kombinierte Magnetbereich so ausgebildet, dass das hochkoerzitive Magnetmaterial des kombinierten Magnetbereichs und das niederkoerzitive Magnetmaterial des kombinierten Magnetbereichs im Wesentlichen die gleiche remanente Flussdichte aufweisen. Der kombinierte Magnetbereich enthält insbesondere die gleiche Menge des hochkoerzitiven und des niederkoerzitiven Magnetmaterials. Die hoch- und niederkoerzitiven Anteile des mindestens einen kombinierten Magnetbereichs können aber auch voneinander abweichen, z.B. aufgrund von unvermeidlichen Drucktoleranzen bei der Herstellung der Magnetbereiche. Bevorzugt sind auch die remanenten Flussdichten des hochkoerzitiven Magnetbereichs und des niederkoerzitiven Magnetbereichs gleich. Zum Beispiel beträgt die remanente Flussdichte des hochkoerzitiven Magnetmaterials des kombinierten Magnetbereichs die Hälfte der remanenten Flussdichte des hochkoerzitiven Magnetbereichs. Und die remanente Flussdichte des niederkoerzitiven Magnetmaterials des kombinierten Magnetbereichs beträgt die Hälfte der remanenten Flussdichte des niederkoerzitiven Magnetbereichs. Der mindestens eine kombinierte Magnetbereich kann eine resultierende remanente Flussdichte aufweisen, die gleich der remanenten Flussdichte des hochkoerzitiven Magnetbereichs und/oder gleich der remanenten Flussdichte des niederkoerzitiven Magnetbereichs ist. Alternativ können die remanenten Flussdichten des hochkoerzitiven, des niederkoerzitiven und des kombinierten Magnetbereichs aber auch verschieden sein.

Zur Prüfung des Wertdokuments werden folgende Schritte durchgeführt: Das Wertdokument bzw. das Sicherheitselement des Wertdokuments wird durch ein erstes Magnetfeld magnetisiert, dessen Magnetfeldstärke größer ist als die erste und als die zweite Koerzitivfeldstärke. Die Magnetisierung des hochkoerzitiven Magnetmaterials (sowohl des hochkoerzitiven als auch des kombinierten Magnetbereichs) und die Magnetisierung des niederkoerzitiven Magnetmaterials (sowohl des niederkoerzitiven als auch des kombinierten Magnetbereichs) werden dabei einheitlich in eine erste Magnetisierungsrichtung ausgerichtet. Die erste Magnetisierungsrichtung ist beispielsweise parallel oder antiparallel zur Transportrichtung des Wertdokuments orientiert. Sie kann aber auch anders, z.B. schräg zur Transportrichtung des Wertdokuments oder senkrecht zur Transportebene des Wertdokuments orientiert sein. Während des ersten Magnetisierens wird kein Magnetsignal detektiert. Nach dem ersten Magnetisieren werden erste Magnetsignale des Sicherheitselements durch einen ersten Magnetdetektor detektiert. Das erste Magnetisieren führt dazu, dass die hochkoerzitiven, die niederkoerzitiven und die kombinierten Magnetbereiche jeweils ein deutliches erstes Magnetsignal erzeugen. Ein weichmagnetischer Magnetbereich zeigt dagegen nur ein verschwindend geringes erstes Magnetsignal.

Anschließend wird das Wertdokument bzw. das Sicherheitselement durch ein zweites Magnetfeld magnetisiert, dessen Magnetfeldstärke kleiner ist als die erste Koerzitivfeldstärke, aber größer ist als die zweite Koerzitivfeldstärke. Die Magnetfeldstärke des ersten Magnetfelds ist um mindestens einen Faktor 2 größer als die Magnetfeldstärke des zweiten Magnetfelds, vorzugsweise um mindestens einen Faktor 3. Das zweite Magnetfeld ist so orientiert, dass die Magnetisierung des niederkoerzitiven Magnetmaterials (sowohl des niederkoerzitiven als auch des kombinierten Magnetbereichs) antiparallel zur ersten Magnetisierungsrichtung ausgerichtet ist. Die Magnetisierung des hochkoerzitiven Magnetmaterials (sowohl des hochkoerzitiven als auch des kombinierten Magnetbereichs) bleibt bei der zweiten Magnetisierung unverändert in der ersten Magnetisierungsrichtung ausgerichtet. Unter Einwirkung des zweiten Magnetfelds, das antiparallel zum ersten Magnetfeld orientiert ist, werden zweite Magnetsignale des Sicherheitselements durch einen zweiten Magnetdetektor detektiert. Das heißt, der Magnetbereich, dessen zweites Magnetsignal detektiert wird, befindet sich während der Detektion seiner zweiten Magnetsignale im zweiten Magnetfeld. Das zweite Magnetfeld ist derart ausgebildet, dass es, bei der Prüfung des Wertdokuments, auf einen zu detektierenden Abschnitt des Sicherheitselements nach dem Detektieren des ersten Magnetsignals des jeweiligen Abschnitts und während des Detektierens des zweiten Magnetsignals des jeweiligen Abschnitts einwirkt. Das zweite Magnetfeld ist insbesondere derart ausgebildet, dass es nicht nur während, sondern auch bereits vor dem Detektieren der zweiten Magnetsignale auf das Sicherheitselement einwirkt. Durch das zweite Magnetfeld wird die Magnetisierung des niederkoerzitiven Magnetmaterials verändert, bevor die zweiten Magnetsignale detektiert werden.

Sowohl das hochkoerzitive als auch das niederkoerzitive Magnetmaterial des Sicherheitselements ist unmittelbar vor und während des Detektierens seiner ersten Magnetsignale in die erste Magnetisierungsrichtung magnetisiert. Das Sicherheitselement wird also, nach dem ersten Magnetisieren durch das erste Magnetfeld und vor dem Detektieren der ersten Magnetsignale, nicht durch ein weiteres Magnetfeld magnetisiert, dessen Magnetfeldstärke kleiner ist als die erste Koerzitivfeldstärke und dessen Richtung sich von der des ersten Magnetfelds unterscheidet. Die ersten Magnetsignale des Sicherheitselements werden nicht unter Einwirkung des ersten und nicht unter Einwirkung des zweiten Magnetfelds detektiert.

Die ersten und die zweiten Magnetsignale werden z.B. analysiert, um mindestens einen Magnetbereich des Sicherheitselements als einen der hochkoerzitiven oder der niederkoerzitiven oder der kombinierten Magnetbereiche oder der weichmagnetischen Magnetbereiche zu identifizieren. Die Erfindung ermöglicht sowohl eine Unterscheidung der hochkoerzitiven, der niederkoerzitiven und der kombinierten Magnetbereiche und erlaubt außerdem, weichmagnetische Magnetbereiche des Sicherheitselements davon zu unterscheiden. Zu deren Erkennung wird also kein zusätzlicher Magnetdetektor benötigt. Es werden also nur zwei Magnetdetektoren benötigt, um diese vier möglichen Sorten der Magnetbereiche, die zu prüfende Sicherheitselemente aufweisen können, eindeutig voneinander zu unterscheiden.

Da die Magnetfeldstärke des zweiten Magnetfelds geringer ist als die erste Koerzitivfeldstärke, wird das hochkoerzitive Magnetmaterial durch das zweite Magnetfeld nicht ummagnetisiert. Die Magnetisierung des niederkoerzitiven Magnetmaterials wird jedoch durch das zweite Magnetfeld antiparallel zur ersten Magnetisierungsrichtung ausgerichtet. Daher unterscheiden sich das zweite Magnetsignal des mindestens einen niederkoerzitiven Magnetbereichs von dessen ersten Magnetsignal. Beispielsweise ist das zweite Magnetsignal des niederkoerzitiven Magnetbereichs im Vergleich zu seinem ersten Magnetsignal im Wesentlichen invertiert.

Außerdem führt die antiparallele Magnetisierung des niederkoerzitiven Magnetmaterials auch dazu, dass sich jeweils das zweite Magnetsignal des mindestens einen kombinierten Magnetbereichs von den zweiten Magnetsignalen der hoch- und niederkoerzitiven Magnetbereiche unterscheidet. Der mindestens eine kombinierte Magnetbereich wird durch das zweite Magnetfeld so magnetisiert, dass eine resultierende Magnetisierung des mindestens einen kombinierten Magnetbereichs, die sich durch das zweite Magnetisieren ergibt, zumindest näherungsweise verschwindet. Zu diesem Zweck sind die kombinierten Magnetbereiche vorzugsweise so ausgebildet, dass das niederkoerzitive Magnetmaterial des kombinierten Magnetbereichs und das hochkoerzitive Magnetmaterial des kombinierten Magnetbereichs zumindest näherungsweise die gleiche remanente Flussdichte aufweisen. Wenn in diesem Fall das niederkoerzitive Magnetmaterial des kombinierten Magnetbereichs durch das zweite Magnetfeld antiparallel zum hochkoerzitiven Magnetmaterial des kombinierten Magnetbereichs magnetisiert wird, wird im Idealfall eine verschwindende resultierende Magnetisierung des jeweiligen kombinierten Magnetbereichs erreicht. Dadurch dass die resultierende Magnetisierung der kombinierten Magnetbereiche nahezu verschwindet, ist es möglich, die zweiten Magnetsignale der kombinierten Magnetbereiche sehr zuverlässig von den zweiten Magnetsignalen der übrigen Magnetbereiche zu unterscheiden. Wird ein deutliches erstes Magnetsignal detektiert, so liegt ein hochkoerzitiver oder ein niederkoerzitiver oder ein kombinierter Magnetbereich vor. Anhand des zweiten Magnetsignals des jeweiligen Magnetbereichs kann dann entschieden werden, ob der jeweilige Magnetbereich ein hochkoerzitiver, niederkoerzitiver oder ein kombinierter Magnetbereich ist. Diejenigen Abschnitte des Sicherheitselements, von denen zwar ein deutliches erstes Magnetsignal detektiert wird, die von denen der zweite Magnetdetektor jedoch ein nahezu verschwindendes zweites Magnetsignal detektiert, werden als kombinierte Magnetbereiche identifiziert.

Die genaue Form des Magnetsignals der einzelnen Magnetbereiche hängt von der Art der verwendeten Magnetdetektoren sowie von der remanenten Flussdichte und von der Länge des jeweiligen Magnetbereichs ab. Beispielsweise können die Magnetsignale der hochkoerzitiven, der niederkoerzitiven und der kombinierten Magnetbereiche jeweils als Einfachpeak oder als Doppelpeak ausgebildet sein. Bei verschwindender resultierender Magnetisierung, wie sie bei den kombinierten Magnetbereichen durch das antiparallele zweite Magnetisieren erzeugt wird, weist das zweite Magnetsignal des kombinierten Magnetbereichs keine ausgeprägten Peaks auf und entspricht etwa einem zweiten Signaloffset des zweiten Magnetsignals.

Die hochkoerzitiven und die niederkoerzitiven Magnetbereiche erzeugen jeweils deutliche erste und deutliche zweite Magnetsignale und lassen sich anhand ihrer Signalform und/oder mit Hilfe eines oder mehrerer Schwellenvergleiche oder mittels anderer Methoden voneinander unterscheiden. Da die Magnetsignale der hoch- und niederkoerzitven Magnetbereiche, je nach Art des verwendeten Magnetdetektors, verschieden ausgebildet sein können, hängt auch die Entscheidung, ob ein Magnetbereich als hochkoerzitiver oder als niederkoerzitiver Magnetbereich identifiziert wird, von der Art des Magnetdetektors ab. Bei manchen Magnetdetektoren ist das zweite Magnetsignal eines hochkoerzitiven Magnetbereiche als positiver Einfachpeak ausgebildet und das zweite Magnetsignal eines niederkoerzitiven Magnetbereichs als negativer Einfachpeak. In diesem Fall kann jeder Magnetbereich, dessen zweites Magnetsignal die obere Schwelle überschreitet, als hochkoerzitiver Magnetbereich identifiziert werden und jeder Magnetbereich, dessen zweites Magnetsignal die untere Schwelle unterschreitet, als niederkoerzitiver Magnetbereich. Bei anderen Magnetdetektoren ist das zweite Magnetsignal der hochkoerzitiven und der niederkoerzitiven Magnetbereiche jeweils als Doppelpeak ausgebildet, wobei der Doppelpeak des niederkoerzitiven Magnetbereichs invers zum Doppelpeak des hochkoerzitiven Magnetbereichs ausgebildet ist. Zur Unterscheidung der hochkoerzitiven von den niederkoerzitiven Magnetbereichen kann z.B. die Signalform der zweiten Magnetsignale analysiert werden.

Zum Prüfen des Sicherheitselements kann eine Auswertung der ersten und zweiten Magnetsignale durchgeführt werden, die zwei Schwellen verwendet, mit denen das jeweilige erste und zweite Magnetsignal des jeweiligen Magnetbereichs verglichen werden. Das erste Magnetsignal wird mit einer ersten oberen Schwelle und mit einer ersten unteren Schwelle verglichen, die unterhalb der ersten oberen Schwelle liegt. Das zweite Magnetsignal wird mit einer zweiten oberen Schwelle und mit einer zweiten unteren Schwelle verglichen, die unterhalb der zweiten oberen Schwelle liegt. Die erste obere Schwelle liegt oberhalb und die erste untere Schwelle liegt unterhalb eines Signaloffsets des ersten Magnetsignals. Die zweite obere Schwelle liegt oberhalb und die zweite untere Schwelle liegt unterhalb eines Signaloffsets des zweiten Magnetsignals. Dadurch dass die zweite obere und die zweite untere Schwelle auf einander gegenüberliegenden Seiten des ersten Signaloffsets angeordnet werden, führt das Vergleichen des zweiten Magnetsignals mit diesen beiden Schwellen zu einer sehr zuverlässigen Unterscheidung der kombinierten Magnetbereiche von den hoch- und niederkoerzitiven Magnetbereichen. Um die Identifizierung der kombinierten Magnetbereiche weiter zu optimieren werden die zweite obere und zweite untere Schwelle vorzugsweise so definiert, dass die beiden Schwellen einen relativ großen Abstand voneinander aufweisen. Der Abstand beträgt z.B. mindestens 50%, vorzugsweise mindestens 75% eines mittleren Signalhubs, den das zweite Magnetsignal der hochkoerzitiven und/oder der niederkoerzitiven Magnetbereiche relativ zum Signaloffset des zweiten Magnetsignals aufweist.

Die obere und/oder die untere Schwelle können in Abhängigkeit des ersten und/oder zweiten Magnetsignals des Sicherheitselements gewählt werden, z.B. in Abhängigkeit eines Signalhubs des ersten und/oder zweiten Magnetsignals, den das erste bzw. zweite Magnetsignal relativ zu seinem Signaloffset aufweist. Damit kann, quasi automatisch, z.B. auf Transportschwankungen des Wertdokuments oder auf herstellungsbedingte Schwankungen der Magnetmaterialmenge in den Magnetbereichen reagiert werden. Die obere Schwelle und/oder die untere Schwelle kann für alle Magnetbereiche gleich gewählt sein, so dass alle ersten bzw. zweiten Magnetsignale der Magnetbereiche mit derselben oberen und mit derselben unteren Schwelle verglichen werden. Diese kann dynamisch in Abhängigkeit des ersten bzw. zweiten Magnetsignals gewählt werden. Liegt der Signalhub der ersten bzw. zweiten Magnetsignale der Magnetbereiche des Sicherheitselements beispielsweise im Mittel relativ hoch bzw. niedrig, so wird auch die obere Schwelle entsprechend erhöht bzw. reduziert.

Zur Auswertung der Magnetsignale können aber auch von dem jeweiligen ersten Magnetsignal abgeleitete Werte und/oder von dem jeweiligen zweiten Magnetsignal abgeleitete Werte mit Schwellen verglichen werden. Der abgeleitete Wert kann der Maximalwert des ersten bzw. des zweiten Magnetsignals sein, das der erste bzw. zweite Magnetdetektor bzw. dessen einzelne magnetosensitive Elemente, an der jeweiligen Position entlang der Längsrichtung des Sicherheitselements detektiert. Der abgeleitete Wert kann auch die Fläche unter dem ersten bzw. zweiten Magnetsignal an der jeweiligen Position entlang des Sicherheitselements sein oder andere Charakteristika des ersten bzw. zweiten Magnetsignals oder Charakteristika von Werten, die von dem ersten und zweiten Magnetsignal abgeleitet wurden. Zum Prüfen des Sicherheitselements können aber auch Werte verwendet werden, die von beiden, d.h. von dem ersten und zweiten Magnetsignal abgeleitet wurden.

Beim Identifizieren der Magnetbereiche wird ein Magnetbereich, dessen erstes Magnetsignal oder von diesem abgeleitete Werte eine erste obere Schwelle überschreiten und/oder eine erste untere Schwelle unterschreiten, und dessen zweites Magnetsignal oder von diesem abgeleitete Werte weder eine zweite obere Schwelle überschreiten noch eine zweite untere Schwelle unterschreiten, als kombinierter Magnetbereich identifiziert. Ein Magnetbereich, dessen erstes Magnetsignal oder von diesem abgeleitete Werte die erste obere Schwelle überschreiten und/oder die erste untere Schwelle unterschreiten, und dessen zweites Magnetsignal oder von diesem abgeleitete Werte die zweite obere Schwelle überschreiten und/oder die zweite untere Schwelle unterschreiten, wird entweder als hochkoerzitiver oder als niederkoerzitiver Magnetbereich identifiziert. Und ein Magnetbereich, dessen erstes Magnetsignal oder von diesem abgeleitete Werte weder eine erste obere Schwelle überschreiten noch eine erste untere Schwelle unterschreiten und dessen zweites Magnetsignal oder von diesem abgeleitete Werte eine zweite obere Schwelle überschreiten und/oder eine zweite untere Schwelle unterschreiten, wird als weichmagnetischer Magnetbereich identifiziert.

Die von dem detektierten ersten bzw. zweiten Magnetsignal abgeleiteten Werte können auch Korrelationswerte sein, die durch Korrelieren des ersten bzw. zweiten Magnetsignals mit einem Basissignal gebildet werden, das charakteristisch ist für den ersten bzw. zweiten Magnetdetektor, bzw. für dessen einzelne magnetosensitive Elemente. Für einen Magnetbereich können einer oder mehrere Korrelationswerte abgeleitet werden. Ein aus dem ersten bzw. zweiten Magnetsignal abgeleiteter Korrelationswert ist z.B. der Maximalwert einer Korrelationskurve, die jeweils für eine Position entlang der Längsrichtung des Sicherheitselements bestimmt wird. Es können aber auch andere Charakteristika der Korrelationskurve verwendet werden.

Insbesondere wird eine Auswertung der Magnetsignale des Sicherheitselements durchgeführt, die für mehrere Magnetbereiche des Sicherheitselements jeweils individuell mindestens einen von dem ersten Magnetsignal des jeweiligen Magnetbereichs abgeleiteten Korrelationswert verwendet. Der Korrelationswert wird durch eine Korrelation des jeweiligen ersten Magnetsignals mit einem ersten Basissignal gebildet, das charakteristisch ist für den ersten Magnetdetektor. Alternativ oder zusätzlich kann für mehrere Magnetbereiche des Sicherheitselements jeweils individuell mindestens ein von dem zweiten Magnetsignal des jeweiligen Magnetbereichs abgeleiteter Korrelationswert verwendet werden, der durch eine Korrelation des jeweiligen zweiten Magnetsignals mit einem zweiten Basissignal gebildet wird, das charakteristisch ist für den zweiten Magnetdetektor.

Im Vergleich zu einer direkten Auswertung der detektierten Magnetsignale selbst ist die Auswertung der durch Korrelation mit dem Basissignal erhaltenen Korrelationswerte vorteilhaft, da in diesem Fall alle detektierten Einzelmesswerte des ersten bzw. zweiten Magnetsignals eines Magnetbereichs in die Auswertung einfließen, d.h. es wird jeweils das gesamte Magnetsignal des jeweiligen Magnetbereichs bewertet. Im Gegensatz dazu tragen bei einem einfachen Schwellenvergleich des detektierten Magnetsignals nur wenige Einzelmesswerte bei, z.B. die, die eine Schwelle überschreiten. Die Korrelation mit dem Basissignal erlaubt daher eine wesentliche robustere Auswertung der detektierten Magnetsignale, die weniger anfällig für Störungen ist als eine direkte Auswertung der detektierten Magnetsignale.

Es wurde herausgefunden, dass es vorteilhaft ist, das erste und/oder zweite Basissignal in Abhängigkeit der Eigenschaften des Magnetbereichs bzw. des Sicherheitselements zu wählen, z.B. abhängig von dessen Ausdehnung in Transportrichtung. Zum Beispiel ist es vorteilhaft, für verschieden breite Sicherheitsfäden verschiedene Basissignale zu verwenden. Bevorzugt wird ein dynamisch erzeugtes Basissignal verwendet. Insbesondere wird das erste Basissignal aus dem ersten Magnetsignal und/oder das zweite Basissignal aus dem zweiten Magnetsignal eines oder mehrerer Magnetbereiche des Sicherheitselements dynamisch, d.h. während der Prüfung des jeweiligen Sicherheitselements, ermittelt. Vorzugsweise werden das erste und/ oder das zweite Basissignal dabei für jedes Sicherheitselement individuell ermittelt. Beispielsweise kann das Basissignal dynamisch durch Mittelwertbildung der detektierten ersten und/ oder zweiten Magnetsignale gebildet werden. Ein dynamisch erzeugtes Basissignal ist vorteilhaft, da dies eine flexible und zuverlässige Wertdokumentprüfung erlaubt. Denn auf diese Weise können auch für fremde Wertdokumente, für die noch kein Basissignal bekannt ist, die oben beschriebenen Korrelationswerte online gebildet und zur Prüfung des Sicherheitselements verwendet werden. Durch Korrelation mit einem dynamisch erzeugten Basissignal werden auch Schwankungen des Magnetsignaldetektion und des herstellungsbedingter Schwankungen der Wertdokumentqualität und der Zustand der Wertdokumente berücksichtigt.

Zur Prüfung des Sicherheitselements können dann die jeweiligen abgeleiteten Korrelationswerte mit einer oberen Schwelle und einer unteren Schwelle verglichen werden und in Abhängigkeit des Über- bzw. Unterschreitens der beiden Schwellen die Magnetbereiche identifiziert werden. Die Länge der einzelnen Magnetbereiche entlang der Längsrichtung des Sicherheitselements kann z.B. aus dem Verlauf der ersten und/oder der zweiten Magnetsignale entlang der Längsrichtung des Sicherheitselements bestimmt werden oder aus dem Verlauf der abgeleiteten Werte, insbesondere der abgeleiteten Korrelationswerte.

An Stelle eines Schwellenvergleichs kann zur Auswertung der abgeleiteten Werte auch eine weitere Korrelationsrechnung durchgeführt werden. Zum Beispiel kann eine Auswertung der ersten Magnetsignale durchgeführt werden, bei welcher die von dem ersten Magnetsignal durch die Korrelation mit dem ersten Basissignal abgeleiteten Korrelationswerte als Funktion der Längsrichtung des Sicherheitselements mit mindestens einem vorbestimmten Referenzverlauf als Funktion der Längsrichtung des Sicherheitselements korreliert werden. Alternativ oder zusätzlich kann die Auswertung auch umfassen, dass die von dem zweiten Magnetsignal durch die Korrelation mit dem zweiten Basissignal abgeleiteten Korrelationswerte als Funktion der Längsrichtung des Sicherheitselements mit mindestens einem vorbestimmten Referenzverlauf als Funktion der Längsrichtung des Sicherheitselements korreliert werden. Beispielsweise sind in der Auswerteeinrichtung Informationen zu dem ersten und dem zweiten Referenzverlauf gespeichert, die den verschiedenen Sicherheitselementen jeweils zugeordnet sind. Die Ergebnisse dieser weiteren Korrelationen der ersten Korrelationswerte und/oder der zweiten Korrelationswerte mit dem jeweiligen Referenzverlauf können zur Prüfung des Sicherheitselements verwendet werden.

Gegebenenfalls weist das Wertdokument auch einen oder mehrere weichmagnetische Magnetbereiche auf, deren zweites Magnetsignal unter Einwirkung des zweiten Magnetfelds auf den jeweiligen weichmagnetischen Bereich detektiert wird. Die weichmagnetischen Magnetbereiche können Teil einer Kodierung des Sicherheitselements sein oder außerhalb des Sicherheitselements auf dem Wertdokument angeordnet sein. Zum Detektieren der außerhalb des Sicherheitselements liegenden weichmagnetischen Magnetbereiche, werden zumindest die zweiten Magnetsignale des Wertdokuments auch außerhalb des Sicherheitselements detektiert. Da das zweite Magnetfeld den jeweiligen weichmagnetischen Bereich während der Detektion der zweiten Magnetsignale magnetisiert, erzeugt das weichmagnetische Magnetmaterial ein deutliches zweites Magnetsignal. Die weichmagnetischen Bereiche des Sicherheitselements können anhand ihres zweiten Magnetsignals und anhand ihres verschwindenden ersten Magnetsignals als weichmagnetische Bereiche identifiziert werden. Zur Prüfung des Wertdokuments können einer oder mehrere Bereiche des Wertdokuments ortsaufgelöst auf ihre magnetischen Eigenschaften überprüft werden.

Die Erfindung betrifft auch eine Vorrichtung zur Prüfung eines Wertdokuments mit einem Sicherheitselement, das mindestens einen der oben genannten hochkoerzitiven und/oder niederkoerzitiven und/oder kombinierten und/oder weichmagnetischen Magnetbereiche aufweist. Mit Hilfe dieser Vorrichtung kann auch eine magnetische Kodierung des Sicherheitselements aus hochkoerzitiven, niederkoerzitiven, kombinierten und weichmagnetischen Magnetbereichen zuverlässig nachgewiesen werden. Die erfindungsgemäße Vorrichtung kann als Sensor zur Prüfung von Wertdokumenten oder als Vorrichtung zur Wertdokumentbearbeitung ausgebildet sein, in die Wertdokumente zu deren Prüfung eingegeben werden können, oder als Anordnung, die zum Einbauen in eine solche Vorrichtung vorgesehen ist.

Die Vorrichtung weist eine erste Magnetisierungseinrichtung zum Bereitstellen des ersten Magnetfelds auf, das zum ersten Magnetisieren des hochkoerzitiven und des niederkoerzitiven Magnetmaterials des Sicherheitselements in eine erste Magnetisierungsrichtung ausgebildet ist. Im Magnetfeld der ersten Magnetisierungseinrichtung befindet sich kein Magnetdetektor. Außerdem weist die Vorrichtung eine zweite Magnetisierungseinrichtung zum Bereitstellen des zweiten Magnetfelds auf, das zum zweiten Magnetisieren des niederkoerzitiven Magnetmaterials des Sicherheitselements in eine zweite Magnetisierungsrichtung ausgebildet ist, die antiparallel zur ersten Magnetisierungsrichtung orientiert ist.

In der Vorrichtung zur Wertdokumentbearbeitung wird die erste Magnetisierungseinrichtung vorzugsweise räumlich getrennt von den beiden Magnetdetektoren und von der zweiten Magnetisierungseinrichtung angeordnet. Bevorzugt weisen die erste Magnetisierungseinrichtung und der erste Magnetdetektor entlang der Transportrichtung des Wertdokuments ein Abstand von mindestens 4 cm, bevorzugt von mindestens 12 cm auf. So werden magnetische Störungen der detektierten Magnetsignale, die ansonsten durch das große erste Magnetfeld auftreten könnten, vermieden. Auch kann die erste Magnetisierungseinrichtung zu Beginn des Wertdokumenttransportwegs und die beiden Magnetdetektoren sowie die zweite Magnetisierungseinrichtung an einer völlig anderen Stelle (nach der ersten Magnetisierungseinrichtung) entlang des Transportwegs angeordnet werden. Durch diese räumliche Trennung kann die erfindungsgemäße Anordnung sehr flexibel eingesetzt werden und z.B. auch in kleine Vorrichtungen zur Wertdokumentbearbeitung eingebaut werden, in denen nur wenig Platz vorhanden ist.

Außerdem weist die Vorrichtung einen ersten Magnetdetektor zum Detektieren von ersten Magnetsignalen des Sicherheitselements und einen zweiten Magnetdetektor zum Detektieren von zweiten Magnetsignalen des Sicherheitselements auf. Der erste Magnetdetektor ist so angeordnet, dass, bei der Prüfung des Wertdokuments, für jeden Abschnitt des Wertdokuments, das erste Magnetsignal erst detektiert wird, nachdem das erste und bevor das zweite Magnetisieren des jeweiligen Abschnitts durchgeführt wurde. Das zweite Magnetfeld ist derart ausgebildet, dass es, bei der Prüfung des Wertdokuments, auf den zu detektierenden Abschnitt des Sicherheitselements nach dem Detektieren des ersten Magnetsignals des jeweiligen Abschnitts und während des Detektierens des zweiten Magnetsignals des jeweiligen Abschnitts einwirkt.

Die zweite Magnetisierungseinrichtung besteht bevorzugt aus einem oder mehreren einseitig zum Transportweg des Wertdokuments angeordneten Magneten, z.B. Permanentmagneten. Dieser mindestens eine Magnet ist auf der Seite des Transportwegs angeordnet, auf der auch der zweite Magnetdetektor angeordnet ist. Gegenüberliegend dazu, auf der anderen Seite des Transportwegs, ist kein weiteres magnetisches Material vorhanden, insbesondere kein weiterer Magnet. Der zweite Magnetdetektor und die zweite Magnetisierungseinrichtung sind vorzugsweise auf derselben Seite der Transportebene angeordnet, wobei der zweite Magnetdetektor zwischen der zweiten Magnetisierungseinrichtung und der Transportebene des Wertdokuments angeordnet ist. Durch die Anordnung des Magneten und des zweiten Magnetdetektors auf derselben Seite der Transportebene, bzw. durch den Verzicht auf weiteres magnetisches Material auf der dem zweiten Magnetdetektor gegenüberliegenden Seite, werden Magnetfeldschwankungen am Ort des zweiten Magnetdetektors vermieden, die ansonsten durch mechanische Erschütterungen der Anordnung auftreten könnten. Bevorzugt sind der mindestens eine Magnet der zweiten Magnetisierungseinrichtung und der zweite Magnetdetektor mechanisch zueinander so fixiert, dass sie eine bauliche Einheit bilden. Zum Beispiel wird der zweite Magnetdetektor zu diesem Zweck mit dem Permanentmagneten, der das zweite Magnetfeld erzeugt, vergossen. Eine geeignete Fixierung kann aber auch durch Klebung, Verschraubung, etc. erreicht werden. Durch die mechanische Fixierung zueinander wird erreicht, dass die Relativposition zwischen dem Permanentmagnet und dem zweiten Magnetdetektor stabil bleibt und mechanische Erschütterungen keine Störungen der zweiten Magnetsignale verursachen.

Bevorzugt ist der zweite Magnetdetektor derart auf dem mindestens einen Magneten der zweiten Magnetisierungseinrichtung angeordnet ist, dass der Abstand zwischen der dem Wertdokument zugewandten Oberfläche des mindestens einen Magneten und den magnetosensitiven Elementen des zweiten Magnetdetektors, entlang der Richtung senkrecht zur Transportebene des Wertdokuments, höchstens 4 mm beträgt. Diese Anordnung des zweiten Magnetdetektors möglichst nah an der Magnet-Oberfläche, hat den Vorteil, dass die zweite Magnetisierungseinrichtung sehr nah an die Transportebene der Wertdokumente angeordnet werden kann. So kann auf einfache Weise ein ausreichend großes zweites Magnetfeld erzeugt werden, um das vorbei transportierte Wertdokument zu magnetisieren. Die magnetosensitiven Elemente des zweiten Magnetdetektors sind bevorzugt im Wesentlichen in einer Symmetrieebene der zweiten Magnetisierungseinrichtung, z.B. mittig auf dem Magneten angeordnet, da sie dort vorteilhaft einem definierten Magnetfeld parallel oder antiparallel zur Transportrichtung ausgesetzt sind. Eine sehr genaue Positionierung der magnetosensitiven Elemente des zweiten Magnetdetektors im Magnetfeld des zweiten Magneten kann dadurch erreicht werden, dass die magnetosensitiven Elemente auf einem gemeinsamen Träger befestigt werden, der in seiner optimalen Position an die zweite Magnetisierungseinrichtung mechanisch fixiert wird.

Die Vorrichtung kann ferner eine Auswerteeinrichtung zum Analysieren der ersten und der zweiten Magnetsignale aufweisen. Die Auswerteeinrichtung ist dazu eingerichtet, das Sicherheitselement auf das Vorhandensein bestimmter hochkoerzitiver und/oder niederkoerzitiver und/oder kombinierter und/oder weichmagnetischer Magnetbereiche zu prüfen, wie oben in Bezug auf das Verfahren erläutert wurde, z.B. um diese Magnetbereiche anhand ihrer ersten und zweiten Magnetsignale voneinander zu unterscheiden. Die Auswerteeinrichtung ist z.B. dazu eingerichtet, eine Magnetkodierung des Sicherheitselements zu verifizieren oder zu ermitteln, an welchen Positionen auf dem Sicherheitselement Magnetbereiche des Sicherheitselements lokalisiert sind, und diese Magnetbereiche zu identifizieren. Die Auswerteeinrichtung kann ein Bestandteil der Vorrichtung sein. Sie kann aber auch eine davon unabhängige Einrichtung sein, an die die ersten und zweiten Magnetsignale übertragen werden.

Der erste und/oder der zweite Magnetdetektor weisen z.B. eine bestimmte Hauptempfindlichkeitsrichtung auf, die parallel oder antiparallel zur ersten Magnetisierungsrichtung orientiert sein kann, oder die senkrecht zur ersten Magnetisierungsrichtung und senkrecht zur Transportebene des Wertdokuments, oder die schräg in der Transportebene liegen kann. Der erste und der zweite Magnetdetektor weisen vorzugsweise die gleiche Hauptempfindlichkeitsrichtung auf. In Bezug auf die Handhabung der Magnetdetektoren ist es besonders vorteilhaft, für den ersten und zweiten Magnetdetektor zwei baugleiche Magnetdetektoren zu verwenden. Insbesondere sind die magnetosensitiven Elemente des zweiten Magnetdetektors derart angeordnet, dass das zweite Magnetfeld möglichst senkrecht zur Hauptempfindlichkeitsrichtung der magnetosensitiven Elemente des zweiten Magnetdetektors orientiert ist. Da so eine magnetische Vorspannung des zweiten Magnetdetektors gering gehalten wird, ist bei manchen Magnetdetektoren ein größerer Dynamikbereich erreichbar. Der erste und zweite Magnetdetektor können als Sensorzeilen ausgebildet sein, die jeweils eine Vielzahl von magnetosensitiven Elementen aufweisen, sie können aber auch als einzelne magnetosensitive Elemente ausgebildet sein. Die magnetosensitiven Elemente der Magnetdetektoren können als magnetoresistive Elemente ausgebildet sein, z.B. als konventionelle magnetoresistive Elemente, GMR-, AMR-, SdT- oder Spinventil-Elemente, es können aber auch induktive Elemente, Hallelemente etc. verwendet werden.

Nachfolgend wird die Erfindung beispielhaft anhand der folgenden Figuren erläutert. Es zeigen:
- Fig. 1a: Ein erstes Ausführungsbeispiel in dreidimensionaler Ansicht,
- Fig. 1b, c: zwei weitere Beispiele der zweiten Magnetisierungseinrichtung,
- Fig. 2a,b: ein weiteres Ausführungsbeispiel, bei dem der erste und zweite Magnetdetektor parallel zur Transportrichtung des Wertdokuments empfindlich sind (Fig. 2a) und schematisch die zugehörigen Magnetsignale M1, M2 als Funktion der Zeit t (Fig. 2b),
- Figur 3a-c: ein weiteres Ausführungsbeispiel, bei dem der erste und zweite Magnetdetektor senkrecht zur Transportebene des Wertdokuments empfindlich sind (Fig. 3a), schematisch die zugehörigen Magnetsignale M1, M2 als Funktion der Zeit t (Fig. 3b) und die durch Korrelation der Magnetsignale M2 mit einem Basissignal B2 erhaltenen Korrelationswerte K2,
- Figur 4a: ein weiteres Ausführungsbeispiel mit zwei Magnetdetektoren, die senkrecht zur Transportrichtung des Sicherheitselements und senkrecht zur Längsrichtung des Sicherheitselements orientiert sind,
- Figur 4b: ein weiteres Ausführungsbeispiel mit zwei Magnetdetektoren, die schräg zur Transportrichtung des Sicherheitselements und schräg zum Sicherheitselement orientiert sind.

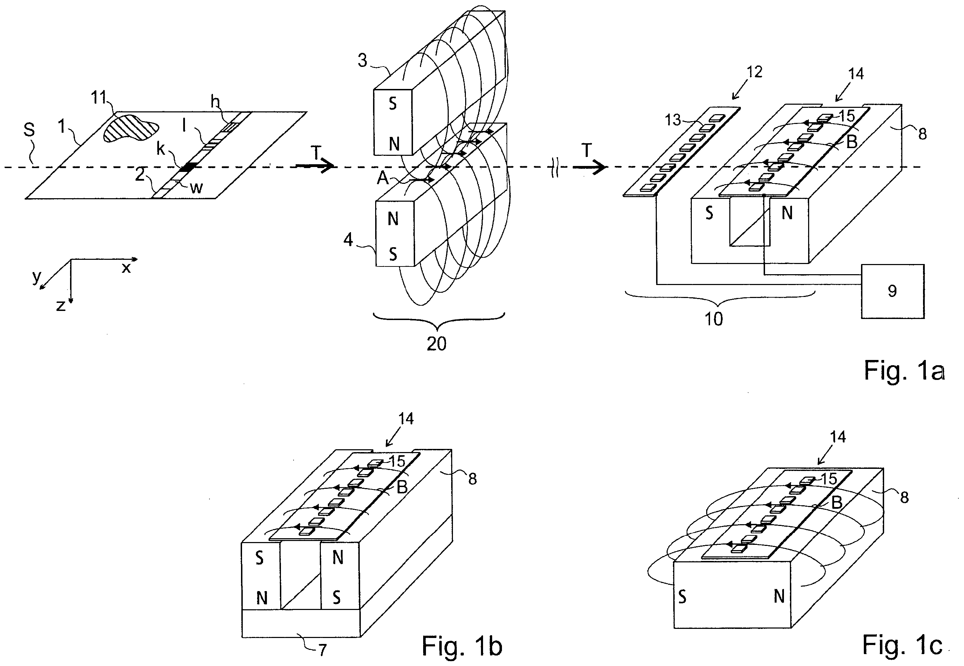

Figur 1 zeigt ein erstes Ausführungsbeispiel der erfindungsgemäßen Vorrichtung. Die gezeigte Vorrichtung ist in einer Vorrichtung zur Wertdokumentbearbeitung enthalten, in die die Wertdokumente 1 einzeln oder stapelweise eingegeben werden, anschließend geprüft, sortiert und in der Vorrichtung zur Wertdokumentbearbeitung abgespeichert oder wieder ausgegeben werden. Ein Wertdokument 1 wird entlang eines Transportwegs S zuerst an einer Magnetisierungseinrichtung 20, zum Bereitstellen eines Magnetfelds A vorbei transportiert und danach an einem Magnetsensor 10 mit zwei Sensorzeilen 12,14. Das Magnetfeld A wird durch zwei einander gegenüberliegende Magnete 3, 4 bereit gestellt, zwischen denen das Wertdokument 1 hindurch transportiert wird. Die Pole N, S der Magnete 3, 4 sind so ausgerichtet, dass sich zwischen diesen ein Magnetfeld A parallel zur Transportrichtung T ergibt. Zu Beginn der Anordnung der Magnete 3, 4 bildet sich bei dieser Magnetanordnung ein Magnetfeld aus, das zu einer vorausgehenden, zusätzlichen Ummagnetisierung des Sicherheitselements führen kann, was jedoch auf die nach dem Magnetfeld A resultierende Magnetisierung des Sicherheitselements keinen Einfluss hat. Alternativ kann die erste Magnetisierungseinrichtung 20 auch nur einseitig zum Transportweg S angeordnet sein, solange dadurch eine ausreichend große Magnetfeldstärke zum Magnetisieren des hochkoerzitiven Magnetmaterials erzielt wird. Zum Beispiel kann das erste Magnetfeld A auch durch nur einen der Magneten 3 oder 4 bereitgestellt werden oder durch einen Hufeisenmagnet analog zu Magnet 8, vgl. Figur 1a rechts, oder durch einen analog zu Figur 1c angeordneten Magneten oder durch eine Magnetanordnung analog zu Figur 1b.

Das Wertdokument 1 weist ein Sicherheitselement 2 mit einer Magnetkodierung auf. Das Sicherheitselement 2 ist in diesem Beispiel als Sicherheitsfaden ausgebildet, der entlang seiner Längsrichtung einen ersten hochkoerzitiven Magnetbereich h, einen niederkoerzitiven Magnetbereich l und gegebenenfalls einen kombinierten Magnetbereich k und gegebenenfalls einen weichmagnetischen Magnetbereich w enthält. Die Erfindung ist aber auch für andere Arten magnetischer Sicherheitselemente von Wertdokumenten geeignet. Zwischen diesen Magnetbereichen h, l, k, w befindet sich nichtmagnetisches Material. Das hochkoerzitive und das niederkoerzitive Magnetmaterial des kombinierten Magnetbereichs k haben etwa die gleiche remanente Flussdichte. Der kombinierte Magnetbereich k enthält die beiden Magnetmaterialien aufeinander angeordnet oder als Mischung. Der weichmagnetische Magnetbereich w enthält ein von diesen Magnetmaterialien verschiedenes weichmagnetisches Material, dessen remanente Flussdichte sehr gering ist.

Das erste Magnetfeld A ist parallel zur Transportrichtung T des Wertdokuments 1 orientiert und weist eine große Magnetfeldstärke auf, die größer ist als die Koerzitivfeldstärken aller magnetischer Materialien des Sicherheitselements 2. Durch das erste Magnetfeld A wird sowohl das hochkoerzitive als auch das niederkoerzitive Magnetmaterial in eine erste Magnetisierungsrichtung ausgerichtet, die in diesem Beispiel parallel zur Transportrichtung T des Wertdokuments 1 orientiert ist (x-Richtung). Demzufolge richtet das Magnetfeld A sowohl die Magnetisierung des hochkoerzitiven Magnetbereichs h als auch die des niederkoerzitiven Magnetbereichs l als auch die des kombinierten Magnetbereichs k des Sicherheitselements 2 in x-Richtung aus.

Nach der ersten Magnetisierung wird das Wertdokument 1 an dem Magnetsensor 10 vorbeitransportiert, der räumlich getrennt von der Anordnung 20 in der Vorrichtung zur Wertdokumentbearbeitung eingebaut ist. Dazwischen können z.B. Verzweigungen oder Umlenkungen des Transportwegs S vorgesehen sein. Der Magnetsensor 10 enthält zwei Sensorzeilen 12, 14, die jeweils eine Vielzahl gleichartiger magnetosensitiver Elemente 13, 15 aufweisen, die in einer Zeile angeordnet sind. Jedes dieser magnetosensitiven Elemente 13, 15 liefert ein Magnetsignal, so dass in diesem Beispiel eine Vielzahl erster Magnetsignale M1 mit Hilfe der magnetosensitiven Elemente 13 und eine Vielzahl zweiter Magnetsignale M2 mit Hilfe der magnetosensitiven Elemente 15 detektiert werden. Jedes Element 13 der ersten Sensorzeile 12 erfasst denselben Abschnitt des vorbeitransportierten Sicherheitselements 2 wie ein dazu korrespondierendes Elemente 15 der zweiten Sensorzeile 14. Jeweils die Magnetsignale zweier miteinander korrespondierender Elemente 13, 15 liefern das erste und zweite Magnetsignal eines bestimmten Abschnitt des Sicherheitselements 2.

Während des Detektierens der ersten Magnetsignale ist das Sicherheitselement 2 keinem Magnetfeld ausgesetzt. Die magnetosensitiven Elemente 15 der zweiten Sensorzeile 14 detektieren die zweiten Magnetsignale M2 des Sicherheitselements 2 unter Einwirkung eines zweiten Magnetfelds B, das vor und während des Detektierens der zweiten Magnetsignale auf das Sicherheitselement 2 einwirkt. Das zweite Magnetfeld B wird durch einen einseitig zum Transportweg S angeordneten Permanentmagneten 8 bereit gestellt und ist derart ausgedehnt, dass es das Sicherheitselement 2 bereits magnetisiert, bevor dieses in den Erfassungsbereich der zweiten Sensorzeile 14 kommt. Die Pole N, S des Magneten 8 sind so ausgerichtet, dass sich in der Transportebene ein Magnetfeld B antiparallel zur Transportrichtung T des Wertdokuments ergibt. Die Magnetfeldstärke des Magnetfelds A beträgt z.B. mindestens das Doppelte der Magnetfeldstärke des Magnetfelds B.

Das zweite Magnetfeld B ist antiparallel zur Transportrichtung T des Wertdokuments 1 orientiert und weist eine Magnetfeldstärke auf, die zwischen den Koerzitivfeldstärken des hoch- und des niederkoerzitiven Magnetmaterials des Sicherheitselements 2 liegt. Das zweite Magnetfeld B magnetisiert nur das niederkoerzitive Magnetmaterial um, und zwar in eine zweite Magnetisierungsrichtung, die antiparallel zur ersten Magnetisierungsrichtung, also antiparallel zur Transportrichtung T orientiert ist (-x-Richtung). Die Magnetisierung des hochkoerzitiven Magnetmaterials bleibt von dem zweiten Magnetfeld B unbeeinflusst und daher in der ersten Magnetisierungsrichtung ausgerichtet. Demzufolge ändert das Magnetfeld B nur die Magnetisierung des niederkoerzitiven Magnetbereichs l und die des kombinierten Magnetbereichs k. Die Magnetisierung des niederkoerzitiven Magnetbereichs l wird durch das zweite Magnetfeld B antiparallel zur ersten Magnetisierungsrichtung ausgerichtet (-x-Richtung). Die Magnetisierung des kombinierten Magnetbereichs k ergibt sich aus der Summe der Magnetisierungen des hochkoerzitiven Anteils und des niederkoerzitiven Anteils des kombinierten Magnetbereichs k. Wenn diese beiden Anteile des kombinierten Magnetbereichs etwa die gleiche remanente Flussdichte aufweisen, heben sich deren Magnetisierungen etwa auf. Das Magnetfeld B bewirkt daher, dass die resultierende Magnetisierung des kombinierten Magnetbereichs k nahezu verschwindet. An Stelle der Magnetfeldrichtungen aus Figur 1 ist es genauso möglich, ein Magnetfeld A antiparallel zur Transportrichtung und ein Magnetfeld B parallel zur Transportrichtung zu verwenden.

Das Detektieren der zweiten Magnetsignale M2 unter Einwirkung des zweiten Magnetfelds B hat den Vorteil, dass die zweite Sensorzeile 14 nicht nur zum Detektieren der verschiedenen Magnetbereiche h. l, k des Sicherheitselements 2 verwendet werden kann, sondern dass diese auch Magnetsignale weichmagnetischer Magnetbereiche w des Sicherheitselements 2 detektieren kann, und auch weichmagnetische Bereiche 11, die auf dem Wertdokument außerhalb des Sicherheitselements 2 vorhanden sein können, vgl. Figur 1.

Die Sensorzeilen 12,14 sind in direkter Nähe zur Transportebene des Wertdokuments 1 angeordnet. Es kann vorgesehen sein, dass die vorbeitransportierten Wertdokumente 1 die Oberfläche der Sensorzeilen 12, 14 berühren, es kann aber auch ein geringer Abstand zwischen der Oberfläche der Sensorzeilen 12, 14 und dem vorbeitransportierten Wertdokument 1 vorgesehen sein, z.B. ein Abstand im mm-Bereich. Die magnetosensitiven Elemente 13 bzw. 15 sind z.B. jeweils auf einer gemeinsamen Leiterplatte angeordnet (Verdrahtung der Leiterplatten nicht gezeigt), und mit einer Auswerteeinrichtung 9 verbunden, die die Magnetsignale der Elemente 13, 15 auswertet.

Der Magnet zur Bereitstellung des zweiten Magnetfelds kann z.B. ein einseitig zum Transportweg S angeordneter Magnet sein, in dessen Symmetrieebene die Sensorzeile 14 positioniert ist. In Figur 1a ist der Magnet 8 ein hufeisenförmiger Permanentmagnet, dessen Nord- und Südpol dem vorbeitransportierten Wertdokument zugewandt sind. Um das Magnetfeld B antiparallel zur Transportrichtung T des Wertdokuments zu erzeugen, können aber auch mehrere Magnete verwendet werden, z.B. zwei Magnete 8 mit umgekehrter Anordnung ihrer Magnetpole, wobei die dem Wertdokument abgewandten Magnetpole der beiden Magnete 8 z.B. durch ein Joch 7 aus magnetischem Stahl verbunden sind, vgl. Figur 1b. Alternativ kann auch ein Magnet 8 verwendet werden, der nicht mit einem seiner Magnetpole, sondern mit einer die Magnetpole verbindenden Seitenwand dem vorbeitransportierten Wertdokument zugewandt ist, vgl. Figur 1c. Auf der Seitenwand ist die Leiterplatte der Sensorzeile 14 befestigt.

Die Leiterplatte der Sensorzeile 14 der magnetosensitiven Elemente 15 und der Magnet 8 sind durch Vergießen mechanisch zueinander so fixiert, dass sie eine bauliche Einheit bilden. Die Auswerteeinrichtung 9 empfängt Magnetsignale von den beiden Sensorzeilen 12, 14 und verarbeitet und analysiert diese. Die Auswerteeinrichtung 9 kann z.B. zusammen mit den Sensorzeilen 12, 14 im selben Gehäuse angeordnet sein. Über eine Schnittstelle können Daten von der Auswerteeinrichtung 9 nach außen gesendet werden, z.B. zu einer Einrichtung, die die Daten weiterverarbeitet oder zu einer Anzeigeeinrichtung, die über das Ergebnis der Wertdokumentprüfung informiert.

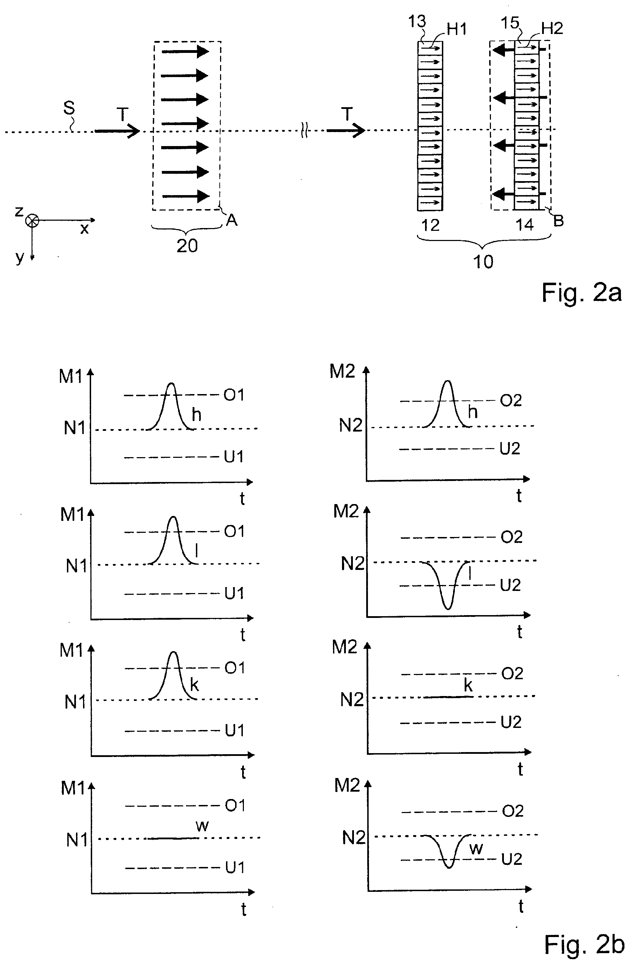

Figur 2a zeigt ein weiteres Ausführungsbeispiel in einer Draufsicht auf die Transportebene (x-y). Das Sicherheitselement 2 des Wertdokuments 1 wird auf die oben beschriebene Weise durch die Magnetfelder A, B magnetisiert und an den beiden Sensorzeilen 12, 14 vorbeitransportiert, die die ersten und zweiten Magnetsignale aufnehmen. Wie in Figur 1 sind auch in diesem Ausführungsbeispiel das erste Magnetfeld A parallel zur Transportrichtung (x) des Wertdokuments und das zweite Magnetfeld B antiparallel dazu (-x) orientiert. Die magnetosensitiven Elemente 13, 15 der ersten und des zweiten Sensorzeile 12, 14 weisen Hauptempfindlichkeitsrichtungen H1 und H2 auf, die in Figur 2 durch Pfeile auf den jeweiligen magnetosensitiven Elementen 13 bzw. 15 eingezeichnet sind. Beispielsweise sind die Hauptempfindlichkeitsrichtung H1, H2 der magnetosensitiven Elemente 13, 15 gleich und parallel zum Magnetfeld A orientiert. Die magnetosensitiven Elemente 13 detektieren erste Magnetsignale M1 ohne Einwirkung eines Magnetfelds auf das Sicherheitselement. Die magnetosensitiven Elemente 15 detektieren zweite Magnetsignale M2 unter der Einwirkung des zweiten Magnetfelds B auf das Sicherheitselement. Die Magnetsignale der Sensorzeilen 12, 14 werden an eine Auswerteeinrichtung weitergeleitet (nicht gezeigt).

In Figur 2b sind die ersten und zweiten Magnetsignale M1, M2 eines hochkoerzitiven Magnetbereichs h (oberstes Diagramm), eines niederkoerzitiven Magnetbereichs l (zweites Diagramm von oben), eines kombinierten Magnetbereichs k (drittes Diagramm von oben) und eine weichmagnetischen Magnetbereichs w (unterstes Diagramm) relativ zu dem jeweiligen Signaloffset N1 bzw. N2 dargestellt. Beim Vorbeitransportieren des Sicherheitselements 2 an den Sensorzeilen 12, 14 erzeugt ein hochkoerzitiver Magnetbereich h an einem magnetosensitiven Element 13 der ersten Sensorzeile 12, das mit h bezeichnete erste Magnetsignal M1 und an einem dazu korrespondierenden magnetosensitiven Element 15 der zweiten Sensorzeile 14 das mit h bezeichnete zweite Magnetsignal M2. Beide Magnetsignale sind etwa gleich und übersteigen eine erste bzw. eine zweite obere Schwelle O1, O2. Der niederkoerzitive Magnetbereich l und der kombinierte Magnetbereich k erzeugen an einem magnetosensitiven Element 13 der ersten Sensorzeile 12 ein mit l bzw. k bezeichnetes erstes Magnetsignal M1, das etwa mit dem ersten Magnetsignal M1 des hochoerzitiven Magnetbereichs h übereinstimmt. Ein magnetosensitives Element 15 der zweiten Sensorzeile 14 detektiert von dem niederkoerzitiven Magnetbereich das mit l bezeichnete zweite Magnetsignal M2, welches die zweite untere Schwelle U2 unterschreitet, vgl. Figur 2b rechts. Anhand des zweiten Magnetsignals M2 können daher hochkoerzitive und niederkoerzitive Magnetbereiche des Sicherheitselements 2 eindeutig voneinander unterschieden werden.

Ein kombinierter Magnetbereich k erzeugt an einem magnetosensitiven Element 15 der zweiten Sensorzeile jedoch, aufgrund der antiparallelen Ausrichtung seines hoch- und niederkoerzitiven Anteils, nur ein vernachlässigbar geringes zweites Magnetsignal M2, vgl. Figur 2b rechts. Das Vorliegen eines kombinierten Magnetbereichs k kann also daran erkannt werden, dass in einem Abschnitt entlang des Sicherheitselements 2 zwar ein deutliches erstes Magnetsignal M1 detektiert wird, aber das zweite Magnetsignal M2 in diesem Abschnitt sehr gering ist, z.B. keine der beiden ersten Schwellen U1, O1 erreicht. Damit kann ein kombinierter Magnetbereich k eindeutig von den hoch- und niederkoerzitiven Magnetbereichen des Sicherheitselements unterschieden werden.

Der weichmagnetische Magnetbereich w des Sicherheitselements erzeugt im Gegensatz zu den anderen Magnetbereichen h, l, k nur ein verschwindend geringes erstes Magnetsignal M1. Da das zweite Magnetfeld B während des Detektierens der zweiten Magnetsignale M2 eine Magnetisierung des weichmagnetischen Magnetbereichs w hervorruft, erzeugt dieser an einem magnetosensitiven Element 15 der zweiten Sensorzeile 14 aber ein deutliches zweites Magnetsignal M2, das die zweite untere Schwelle U2 unterschreitet, vgl. Figur 2b rechts unten.

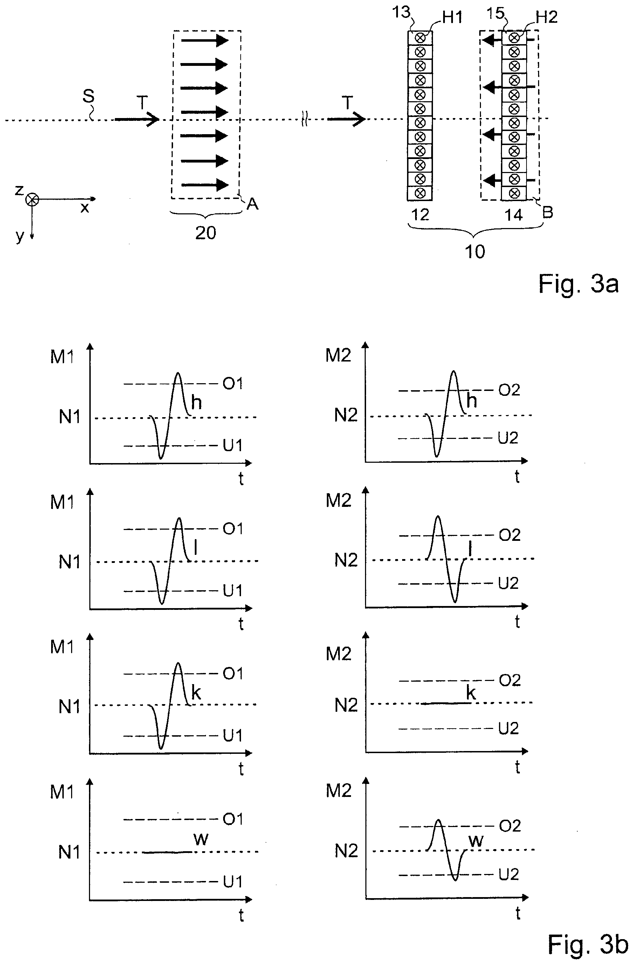

Figur 3a zeigt ein weiteres Ausführungsbeispiel mit antiparallelen Magnetfeldern A, B entsprechend Figur 2a. Der erste und zweite Magnetdetektor bestehen in diesem Beispiel je aus einer Sensorzeile 12 bzw. 14, deren magnetosensitive Elemente 13, 15 Hauptempfindlichkeitsrichtungen H1, H2 haben, die senkrecht zur Transportebene des Wertdokuments 1 orientiert sind (z-Richtung). Die Magnetsignale der Sensorzeilen 12,14 werden an eine Auswerteeinrichtung weitergeleitet (nicht gezeigt), die die ersten und zweiten Magnetsignale weiterverarbeitet. Im Vergleich zum Beispiel aus Figur 2a ergeben sich, aufgrund der veränderten Hauptempfindlichkeitsrichtungen H1, H2 auch andere erste und zweite Magnetsignale M1, M2, vgl. Figur 3b. Das erste und zweite Magnetsignal eines hochkoerzitiven Magnetbereichs h überschreiten beide die jeweilige obere Schwelle O1 bzw. O2 und unterschreiten beiden die jeweilige untere Schwelle U1 bzw. U2, vgl. Figur 3b oben. Ein niederkoerzitiver Magnetbereich l liefert ebenfalls erste und zweite Magnetsignale, die beide obere Schwellen O1 bzw. O2 überschreiten und beide untere Schwellen U1 bzw. U2 unterschreiten. Während die ersten Magnetsignale M1 des hoch- und niederkoerzitiven Magnetbereichs h, l etwa gleich sind, weist das zweite Magnetsignal M2 des niederkoerzitiven Magnetbereichs l eine dazu inverse Signalform auf, vgl. Figur 3b rechts. Der niederkoerzitive Magnetbereich l kann daher anhand der Signalform seines zweiten Magnetsignals M1 von den hochkoerzitiven Magnetbereichen h unterschieden werden.

Ein kombinierter Magnetbereich k erzeugt ein erstes Magnetsignal, das mit dem des hochkoerzitiven und des niederkoerzitiven Magnetbereichs vergleichbar ist. Aufgrund der antiparallelen Ausrichtung seines hoch- und niederkoerzitiven Anteils, erzeugt ein kombinierter Magnetbereich k aber wieder nur ein vernachlässigbar geringes zweites Magnetsignal M2, vgl. Figur 3b rechts. Das Vorliegen eines kombinierten Magnetbereichs k kann also auch in diesem Beispiel daran erkannt werden, dass in einem Abschnitt entlang des Sicherheitselements 2 zwar ein deutliches erstes Magnetsignal M1 detektiert wird, aber das zweite Magnetsignal M2 in diesem Abschnitt sehr gering ist, z.B. keine der beiden zweiten Schwellen U2, O2 erreicht.

Auch in diesem Beispiel erzeugt der weichmagnetische Magnetbereich w des Sicherheitselements im Gegensatz zu den anderen Magnetbereichen h, l, k nur ein verschwindend geringes erstes Magnetsignal M1. Da das zweite Magnetfeld B während des Detektierens der zweiten Magnetsignale M2 eine Magnetisierung des weichmagnetischen Magnetbereichs w hervorruft, erzeugt dieser an einem magnetosensitiven Element 15 der zweiten Sensorzeile 14 aber ein deutliches zweites Magnetsignal M2, das die zweite obere Schwelle überschreitet und die zweite untere Schwelle U2 unterschreitet, vgl. Figur 3b rechts unten.

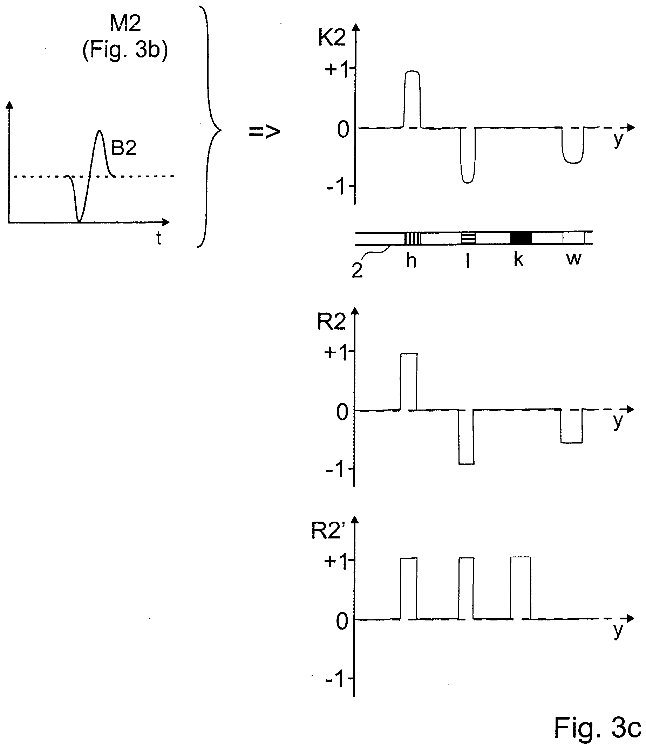

Figur 3c verdeutlicht eine vorteilhafte Auswertung der Magnetsignale des Sicherheitselements. Zur Auswertung der ersten bzw. zweiten Magnetsignale wird ein dynamisch aus dem ersten bzw. zweiten Magnetsignal erzeugtes Basissignal B1 bzw. B2 verwendet, das charakteristisch ist für den ersten bzw. zweiten Magnetdetektor 12, 14. An jedem Detektionsort y entlang des Sicherheitselements 2 wird das an diesem Ort detektierte Magnetsignal M1 bzw. M2 mit dem Basissignal B1 bzw. B2 korreliert. In Figur 3c links oben ist beispielhaft ein für das Magnetsignal M2 des Ausführungsbeispiels der Figuren 3a,b geeignetes Basissignal B2 skizziert. Die Korrelation des Basissignals B2 mit dem zweiten Magnetsignal M2 ergibt einen Korrelationswert K2, der in Figur 3c rechts oben als Funktion des Detektionsorts y aufgetragen ist. Als Korrelationswert K2 wird z.B. für jede Position y das Maximum der Korrelation des Basissignals B2 mit dem zweiten Magnetsignal M2 verwendet. Die Detektionsorte entlang der y-Richtung liegen hier so eng, dass für jeden der Magnetbereiche h, l, k, w individuell mehrere Korrelationswerte K2 berechnet werden können. Die Korrelationswerte K2(y) spiegeln die Anordnung der Magnetbereiche h, l, k, w entlang des Sicherheitselements 2 wider. Aufgrund der großen Ähnlichkeit der Form und Höhe des zweiten Magnetsignale M2 des hochkoerzitiven Magnetbereichs h mit dem Basissignal B2 liegen dessen Korrelationswerte K2 annähernd bei +1. Die Korrelationswerte K2 des niederkoerzitiven Magnetbereichs l liegen dagegen annähernd bei -1, da dessen zweites Magnetsignal M2 invers zum Basissignal B2 ausgebildet ist, vgl. Figur 3b. Die Korrelationswerte K2 des weichmagnetischen Magnetbereichs w erreichen, aufgrund der geringeren Magnetsignalamplitude des zweitens Magnetsignals M2, einen negativen Wert oberhalb von -1, vgl. Figur 3b. Für den kombinierten Magnetbereich k ergeben sich, aufgrund des verschwindend geringen zweiten Magnetsignals M2, nahezu verschwindende Korrelationswerte K2. Bei der Auswertung werden die von dem zweiten Magnetsignal M2 abgeleiteten Korrelationswerte K2(y) als Funktion der Längsrichtung y des Sicherheitselements 2 verwendet. Analog dazu werden aus dem ersten Magnetsignal M1 erste Korrelationswerte K1(y) durch Korrelation mit einem ersten Basissignal B1 gebildet (nicht gezeigt), das ähnlich zu oder gleich wie B2 ausgebildet sein kann.

Die Korrelationswerte K1(y) bzw. K2(y) des ersten bzw. zum zweiten Magnetsignals können - analog zum ersten und zweiten Magnetsignal selbst - mit jeweils einer oberen O1 bzw. O2 und einer unteren Schwelle U1 bzw. U2 verglichen werden. Alternativ zu einem Vergleich der Korrelationswerte mit Schwellen können die Korrelationswerte aber auch, durch Berechnung einer weiteren Korrelation, mit mindestens einem vorbestimmten Referenzverlauf als Funktion der Längsrichtung y des Sicherheitselements korreliert werden. Das Ergebnis dieser weiteren Korrelation kann zur Prüfung des Sicherheitselements, z.B. zur Echtheitsprüfung verwendet werden. Zum Beispiel ist jeder Sorte eines Sicherheitselements ein Referenzverlauf R1(y) für die Korrelationswerte K1(y) des ersten Magnetsignals M1 und ein Referenzverlauf R2(y) für die Korrelationswerte K2(y) des zweiten Magnetsignals M2 zugeordnet. Insbesondere können verschiedene Referenzverläufe R1(y), R2(y), R1'(y), R2'(y), etc. für verschiedene Wertdokumentarten vorbestimmt sein.

In Figur 3c ist der Referenzverlauf R2(y) für das zweite Magnetsignal M2 des in Figur 3c skizzierten Sicherheitselements 2 gezeigt. Bei einer sehr guten Übereinstimmung des Verlaufs der Korrelationswerte K2(y) mit dem für das Sicherheitselement 2 vorbestimmten Referenzverlauf R2(y) liefert die weitere Korrelation einen Zahlenwert von +1. Mit dem Referenzverlauf R2'(y), der für ein anderes Sicherheitselements gilt, stimmt der Verlauf der Korrelationswerte K2(y) dagegen nur im Bereich des hochkoerzitiven Magnetbereichs h etwa überein, während im Abschnitt der Magnetbereiche l, k, w der Referenzverlauf R2'(y) völlig anders verläuft. Die weitere Korrelation zum Refernzverlauf R2'(y) ergibt daher einen sehr geringen Zahlenwert von knapp über 0, aber weit geringer als +1. Werden die Korrelationswerte K2(y) des Sicherheitselements 2 auf Übereinstimmung mit dem Referenzverlauf R2(y) geprüft, so würde es diese Prüfung bestehen. Eine Prüfung auf Übereinstimmung mit dem Referenzverlauf R2'(y) würde das Sicherheitselement dagegen nicht bestehen. Zur Prüfung des Sicherheitselements kann das Ergebnis der weiteren Korrelation, die für die ersten und/oder für die zweiten Korrelationswerte K1(y) bzw. K2(y) durchgeführt wird, z.B. jeweils mit einem Mindestwert verglichen werden.

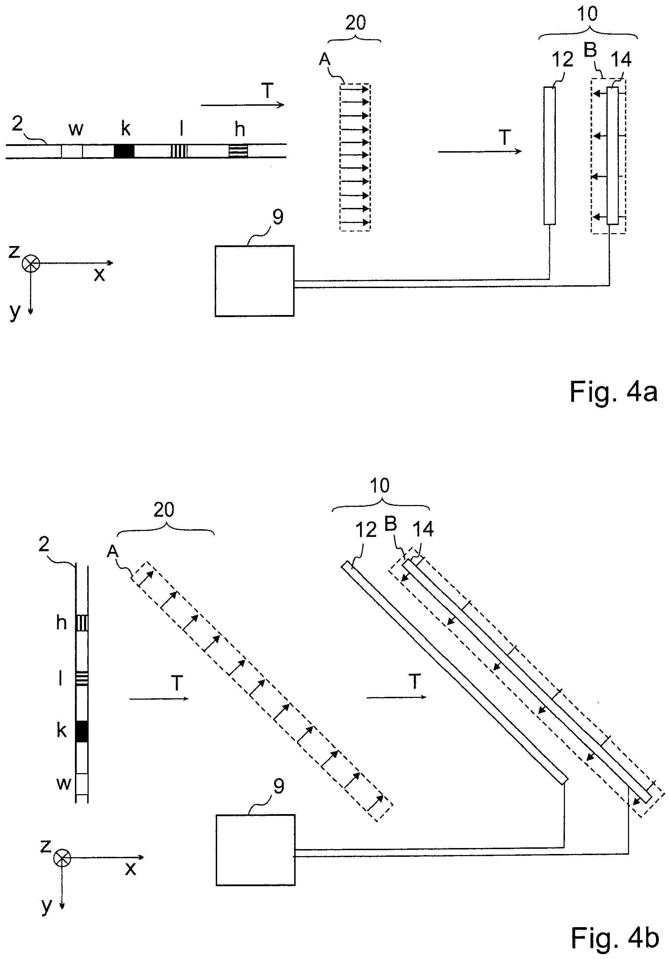

In Figur 4a ist ein weiteres Ausführungsbeispiel einer Vorrichtung zur Prüfung eines Wertdokuments 1 skizziert, bei der ein Wertdokument (nicht gezeigt), das ein Sicherheitselement 2 enthält, entlang einer Transportrichtung T an der Vorrichtung vorbei transportiert wird. Die Vorrichtung ist zur Prüfung eines Sicherheitselements 2 ausgebildet, dessen Längsrichtung parallel zur Transportrichtung T des Wertdokuments verläuft. Die Vorrichtung weist eine Anordnung aus einer Magnetisierungseinrichtung 20 auf, die ein erstes Magnetfeld A parallel zur Transportrichtung T des Wertdokuments bereit stellt. Die Vorrichtung enthält außerdem einen ersten Magnetdetektor 12, und einen zweiten Magnetdetektor 14, die, in Transportrichtung T betrachtet, beide nach der Magnetisierungseinrichtung 20 angeordnet sind. Die beiden Magnetdetektoren 12, 14 sind senkrecht zu Längsrichtung des Sicherheitselements 2 orientiert und besitzen jeweils nur ein einzelnes magnetosensitives Element, das zumindest zum Detektieren von Magnetfeldern parallel und antiparallel zur Transportrichtung T ausgebildet ist. Wie in den vorherigen Ausführungsbeispielen detektiert der erste Magnetdetektor 12 erste Magnetsignale M1 ohne Einwirkung eines Magnetfelds und der zweite Magnetdetektor 14 detektiert zweite Magnetsignale M2 unter der Einwirkung eines zweiten Magnetfelds B, das antiparallel zum ersten Magnetfeld A orientiert ist. Die Vorrichtung weist außerdem eine Auswerteeinrichtung 9 auf, die mit dem ersten und dem zweiten Magnetdetektor 12, 14 verbunden ist. Im Gegensatz zu den vorhergehenden Beispielen werden die ersten Magnetsignale M1 wie auch die zweiten Magnetsignale M2 der verschiedenen Magnetbereiche h, l, k, w des Sicherheitselements 2 in diesem Beispiel jeweils zeitlich nacheinander detektiert. Je nach Empfindlichkeitsrichtung der Magnetdetektoren 12,14, können sich dabei erste und zweite Magnetsignale ergeben, die mit denen der Figuren 2b bzw. 3b vergleichbar sind und analog dazu ausgewertet werden können.

Figur 4b zeigt ein weiteres Ausführungsbeispiel, das weitgehend dem Ausführungsbeispiel der Figur 4a entspricht. Im Unterschied dazu sind bei diesem Ausführungsbeispiel die Magnetisierungseinrichtung 20 zur Detektion des ersten Magnetfelds A und die Magnetisierungseinrichtung zur Detektion des zweiten Magnetfelds (nicht gezeigt) sowie die Magnetdetektoren 12, 14 aber schräg zur Transportrichtung T des Sicherheitselements 2 orientiert. Durch die Schrägstellung kann auch ohne den Einsatz aufwendiger Sensorzeilen eine ortsaufgelöste Detektion des Sicherheitselements erreicht werden. Die beiden magnetosensitiven Elemente der Magnetdetektoren 12, 14 detektieren die ersten und die zweiten Magnetsignale der verschiedenen Magnetbereiche h, l, k, w analog zum Beispiel der Figur 4a, jeweils zeitlich nacheinander. Die Auswertung kann ebenfalls wie oben beschrieben erfolgen.

## Patentansprüche

1. Verfahren zur Prüfung eines Wertdokuments (1), das ein Sicherheitselement (2) mit mehreren Magnetbereichen (h, l, k, w) aufweist, wobei die mehreren Magnetbereiche des Sicherheitselements mindestens einen hochkoerzitiven Magnetbereich (h) aufweisen, der ein hochkoerzitives Magnetmaterial mit einer ersten Koerzitivfeldstärke enthält, und gegebenenfalls mindestens einen niederkoerzitiven Magnetbereich (l), der ein niederkoerzitives Magnetmaterial mit einer zweiten Koerzitivfeldstärke enthält, die geringer ist als die erste Koerzitivfeldstärke, und/oder mindestens einen kombinierten Magnetbereich (k), der sowohl das hochkoerzitive als auch das niederkoerzitive Magnetmaterial enthält, wobei bei dem Verfahren folgende Schritte durchgeführt werden:
- Erstes Magnetisieren des Sicherheitselements (2) durch ein erstes Magnetfeld (A), dessen Magnetfeldstärke größer ist als die erste Koerzitivfeldstärke, so dass die Magnetisierung des hochkoerzitiven Magnetmaterials und die Magnetisierung des niederkoerzitiven Magnetmaterials in eine erste Magnetisierungsrichtung ausgerichtet werden, und danach
- Detektieren von ersten Magnetsignalen (M1) des Sicherheitselements (2) durch einen ersten Magnetdetektor (12), und danach
- zweites Magnetisieren des Sicherheitselements (2) durch ein zweites Magnetfeld (B), dessen Magnetfeldstärke kleiner ist als die erste Koerzitivfeldstärke, aber größer ist als die zweite Koerzitivfeldstärke, wobei das zweite Magnetfeld (B) so orientiert ist, dass die Magnetisierung des niederkoerzitiven Magnetmaterials durch das zweite Magnetisieren antiparallel zur ersten Magnetisierungsrichtung ausgerichtet wird, und Detektieren von zweiten Magnetsignalen (M2) des Sicherheitselements (2) durch einen zweiten Magnetdetektor (14), **dadurch gekennzeichnet, dass** die zweiten Magnetsignale (M2) des Sicherheitselements unter der Einwirkung des zweiten Magnetfelds (B) detektiert werden, wobei sich der jeweilige Magnetbereich, dessen zweites Magnetsignal detektiert wird, während der Detektion seiner zweiten Magnetsignale im zweiten Magnetfeld befindet, dessen Magnetfeldstärke kleiner ist als die erste Koerzitivfeldstärke, aber größer ist als die zweite Koerzitivfeldstärke.

2. Verfahren nach Anspruch 1, **dadurch gekennzeichnet, dass** der mindestens eine kombinierte Magnetbereich (k) durch das zweite Magnetfeld (B) so magnetisiert wird, dass eine resultierende Magnetisierung des mindestens einen kombinierten Magnetbereichs (k), die sich durch das zweite Magnetisieren ergibt, zumindest näherungsweise verschwindet.

3. Verfahren nach einem der vorhergehenden Ansprüche, **dadurch gekennzeichnet, dass** durch den zweiten Magnetdetektor (14) auch zweite Magnetsignale (M2) eines oder mehrerer weichmagnetischer Magnetbereiche (11, w) des Wertdokuments (1) detektiert werden.

4. Verfahren nach einem der vorhergehenden Ansprüche, **dadurch gekennzeichnet, dass** sowohl das hochkoerzitive und als auch das niederkoerzitive Magnetmaterial des Sicherheitselements unmittelbar vor und während des Detektierens der ersten Magnetsignale (M1) des jeweiligen Magnetbereichs in die erste Magnetisierungsrichtung magnetisiert ist.

5. Verfahren nach einem der vorhergehenden Ansprüche, **dadurch gekennzeichnet, dass** eine Auswertung der Magnetsignale des Sicherheitselements durchgeführt wird, bei der
- für mehrere Magnetbereiche (h, l, k, w) des Sicherheitselements jeweils individuell mindestens ein von dem ersten Magnetsignal (M1) des jeweiligen Magnetbereichs abgeleiteter Korrelationswert (K1) verwendet wird, der durch eine Korrelation des jeweiligen ersten Magnetsignals (M1) mit einem ersten Basissignal (B1) gebildet wird, das charakteristisch ist für den ersten Magnetdetektor (12) und/oder
- für mehrere Magnetbereiche (h, l, k, w) des Sicherheitselements jeweils individuell mindestens ein von dem zweiten Magnetsignal (M2) des jeweiligen Magnetbereichs abgeleiteter Korrelationswert (K2) verwendet wird, der durch eine Korrelation des jeweiligen zweiten Magnetsignals (M2) mit einem zweiten Basissignal (B2) gebildet wird, das charakteristisch ist für den zweiten Magnetdetektor (14).

6. Verfahren nach Anspruch 5, **dadurch gekennzeichnet, dass** das erste und/oder das zweite Basissignal (B1, B2) in Abhängigkeit der Eigenschaften des Sicherheitselements bzw. des jeweiligen Magnetbereichs gewählt wird, insbesondere in Abhängigkeit der Ausdehnung des Sicherheitselements (2) bzw. des jeweiligen Magnetbereichs entlang einer Transportrichtung des Wertdokuments.

7. Verfahren nach Anspruch 5 oder 6, **dadurch gekennzeichnet, dass** das erste Basissignal (B1) aus dem ersten Magnetsignal (M1) und/oder dass das zweite Basissignal (B1) aus dem zweiten Magnetsignal (M2) eines oder mehrerer Magnetbereiche (h, l, k. w) des Sicherheitselements dynamisch ermittelt wird, wobei das erste und/oder das zweite Basissignal (B1, B2) vorzugsweise für jedes Sicherheitselement individuell ermittelt wird.

8. Verfahren nach einem der Ansprüche 5 bis 7, **dadurch gekennzeichnet, dass** eine Auswertung durchgeführt wird, bei der
- die von dem ersten Magnetsignal (M1) abgeleiteten Korrelationswerte (K1) als Funktion der Längsrichtung (y) des Sicherheitselements mit mindestens einem vorbestimmten Referenzverlauf (R1, R1') als Funktion der Längsrichtung (y) des Sicherheitselements korreliert werden, und das Ergebnis dieser weiteren Korrelation zur Prüfung des Sicherheitselements verwendet wird, und/oder
- die von dem zweiten Magnetsignal (M2) abgeleiteten Korrelationswerte (K2) als Funktion der Längsrichtung (y) des Sicherheitselements mit mindestens einem vorbestimmten Referenzverlauf (R2, R2') als Funktion der Längsrichtung (y) des Sicherheitselements korreliert werden, und das Ergebnis dieser weiteren Korrelation zur Prüfung des Sicherheitselements verwendet wird.

9. Verfahren nach einem der vorhergehenden Ansprüche, **dadurch gekennzeichnet, dass** ein Magnetbereich, dessen erstes Magnetsignal (M1) oder von diesem abgeleitete Werte, insbesondere Korrelationswerte (K1), eine erste obere Schwelle (O1) überschreiten und/oder eine erste untere Schwelle (U1) unterschreiten, und dessen zweites Magnetsignal (M2) oder von diesem abgeleitete Werte, insbesondere Korrelationswerte (K2), weder eine zweite obere Schwelle (O2) überschreiten noch eine zweite untere Schwelle (U2) unterschreiten, als kombinierter Magnetbereich (k) identifiziert wird.

10. Verfahren nach einem der vorhergehenden Ansprüche, **dadurch gekennzeichnet, dass** ein Magnetbereich, dessen erstes Magnetsignal (M1) oder von diesem abgeleitete Werte (K1), insbesondere Korrelationswerte (K1), weder eine erste obere Schwelle (O1) überschreiten noch eine erste untere Schwelle (U1) unterschreiten, und dessen zweites Magnetsignal (M2) oder von diesem abgeleitete Werte (K2), insbesondere Korrelationswerte (K2), eine zweite obere Schwelle (O2) überschreiten und/oder eine zweite untere Schwelle (U2) unterschreiten, als weichmagnetischer Magnetbereich (w) identifiziert wird.

11. Vorrichtung zur Prüfung eines Wertdokuments (1), das ein Sicherheitselement (2) mit hochkoerzitivem Magnetmaterial einer ersten Koerzitivfeldstärke und mit niederkoerzitivem Magnetmaterial einer zweiten Koerzitivfeldstärke aufweisen kann, wobei die Vorrichtung entlang einer Transportrichtung (T) des Wertdokuments nacheinander umfasst:
- eine erste Magnetisierungseinrichtung (3, 4, 20) zum Bereitstellen eines ersten Magnetfelds (A), das zum ersten Magnetisieren des hochkoerzitiven und des niederkoerzitiven Magnetmaterials in eine erste Magnetisierungsrichtung ausgebildet ist, wobei die zum ersten Magnetisieren verwendete Magnetfeldstärke größer ist als die erste Koerzitivfeldstärke, und danach
- einen ersten Magnetdetektor (12) zum Detektieren von ersten Magnetsignalen (M1) des Sicherheitselements (2), und danach
- eine zweite Magnetisierungseinrichtung (8) zum Bereitstellen eines zweiten Magnetfelds (B), das zum zweiten Magnetisieren des niederkoerzitiven Magnetmaterials in eine zweite Magnetisierungsrichtung ausgebildet ist, die antiparallel zur ersten Magnetisierungsrichtung orientiert ist, wobei die zum zweiten Magnetisieren verwendete Magnetfeldstärke kleiner ist als die erste Koerzitivfeldstärke, aber größer ist als die zweite Koerzitivfeldstärke, und einen zweiten Magnetdetektor (14) zum Detektieren von zweiten Magnetsignalen (M2) des Sicherheitselements (2),
**dadurch gekennzeichnet, dass**
das zweite Magnetfeld (B) derart ausgebildet ist, dass die zweiten Magnetsignale (M2) des Sicherheitselements unter der Einwirkung des zweiten Magnetfelds (B) detektiert werden, wobei sich der jeweilige Magnetbereich, dessen zweites Magnetsignal detektiert wird, während der Detektion seiner zweiten Magnetsignale im zweiten Magnetfeld befindet, dessen Magnetfeldstärke kleiner ist als die erste Koerzitivfeldstärke, aber größer ist als die zweite Koerzitivfeldstärke.

12. Vorrichtung nach Anspruch 11, **dadurch gekennzeichnet, dass** die zweite Magnetisierungseinrichtung einen oder mehrere einseitig zum Transportweg (S) des Wertdokuments angeordnete Magnete (8) aufweist, der/die auf derjenigen Seite des Transportwegs (S) angeordnet ist/sind, auf der auch der zweite Magnetdetektor (14) angeordnet ist.

13. Vorrichtung nach einem der Ansprüche 11 bis 12, **dadurch gekennzeichnet, dass** der mindestens eine Magnet (8) der zweiten Magnetisierungseinrichtung und der zweite Magnetdetektor (14) mechanisch so zueinander fixiert sind, dass sie eine bauliche Einheit bilden.

14. Vorrichtung nach einem der Ansprüche 11 bis 13, **dadurch gekennzeichnet, dass** der zweite Magnetdetektor (14) derart auf dem mindestens einen Magneten (8) angeordnet ist, dass der Abstand zwischen der Oberfläche des mindestens einen Magneten (8) und den magnetosensitiven Elementen (15) des zweiten Magnetdetektors (14), entlang der Richtung senkrecht zur Transportebene des Wertdokuments, höchstens 4 mm beträgt.

15. Vorrichtung nach einem der Ansprüche 11 bis 14, **dadurch gekennzeichnet, dass** die erste Magnetisierungsrichtung parallel oder antiparallel zur Transportrichtung (T) des Wertdokuments (1) orientiert ist.

## Claims

1. A method for checking a value document (1) which has a security element (2) having a plurality of magnetic regions (h, 1, k, w), wherein the plurality of magnetic regions of the security element has at least one high-coercivity magnetic region (h) which contains a high-coercivity magnetic material having a first coercive field strength, and optionally at least one low-coercivity magnetic region (1) which contains a low-coercivity magnetic material having a second coercive field strength which is lower than the first coercive field strength, and/or at least one combined magnetic region (k) which contains the high-coercivity as well as the low-coercivity magnetic material, wherein in the method the following steps are carried out:
- effecting first magnetizing of the security element (2) by a first magnetic field (A) whose magnetic field strength is greater than the first coercive field strength, so that the magnetization of the high-coercivity magnetic material and the magnetization of the low-coercivity magnetic material are aligned in a first magnetization direction, and thereafter
- detecting first magnetic signals (M1) of the security element (2) by a first magnetic detector (12), and thereafter
- effecting second magnetizing of the security element (2) by a second magnetic field (B) whose magnetic field strength is smaller than the first coercive field strength, but is greater than the second coercive field strength, wherein the second magnetic field (B) is so oriented that the magnetization of the low-coercivity magnetic material is aligned anti-parallel to the first magnetization direction by the second magnetizing, and detecting second magnetic signals (M2) of the security element (2) by a second magnetic detector (14),
**characterized in that** the second magnetic signals (M2) of the security element are detected under the action of the second magnetic field (B), wherein the respective magnetic region whose second magnetic signal is detected, is located, during the detection of its second magnetic signals, in the second magnetic field whose magnetic field strength is smaller than the first coercive field strength, but greater than the second coercive field strength.

2. The method according to claim 1, **characterized in that** the at least one combined magnetic region (k) is so magnetized by the second magnetic field (B) that a resultant magnetization of the at least one combined magnetic region (k), which arises through the second magnetizing, vanishes at least approximately.

3. The method according to either of the preceding claims, **characterized in that** there are also detected by the second magnetic detector (14) second magnetic signals (M2) of one or several soft-magnetic magnetic regions (11, w) of the value document (1).

4. The method according to any of the preceding claims, **characterized in that** the high-coercivity as well as the low-coercivity magnetic material of the security element is magnetized in the first magnetization direction immediately before and during the detecting of the first magnetic signals (M1) of the respective magnetic region.

5. The method according to any of the preceding claims, **characterized in that** there is carried out an evaluation of the magnetic signals of the security element, wherein
- for a plurality of magnetic regions (h, 1, k, w) of the security element there is respectively employed individually at least one correlation value (K1) derived from the first magnetic signal (M1) of the respective magnetic region, said value being formed by a correlation of the respective first magnetic signal (M1) with a first base signal (B1) which is characteristic of the first magnetic detector (12), and/or
- for a plurality of magnetic regions (h, 1, k, w) of the security element there is respectively employed individually at least one correlation value (K2) derived from the second magnetic signal (M2) of the respective magnetic region, said value being formed by a correlation of the respective second magnetic signal (M2) with a second base signal (B2) which is characteristic of the second magnetic detector (14).

6. The method according to claim 5, **characterized in that** the first and/or the second base signal (B1, B2) is chosen in dependence on the properties of the security element or of the respective magnetic region, in particular in dependence on the extension of the security element (2) or of the respective magnetic region along a transport direction of the value document.

7. The method according to claim 5 or 6, **characterized in that** the first base signal (B1) is dynamically established from the first magnetic signal (M1), and/or the second base signal (B1) from the second magnetic signal (M2), of one or several magnetic regions (h, 1, k, w) of the security element, the first and/or the second base signal (B1, B2) preferably being established individually for each security element.

8. The method according to any of claims 5 to 7, **characterized in that** there is carried out an evaluation wherein
- the correlation values (K1) derived from the first magnetic signal (M1), as a function of the longitudinal direction (y) of the security element, are correlated with at least one predetermined reference pattern (R1, R1') as a function of the longitudinal direction (y) of the security element, and the result of this further correlation is employed for checking the security element, and/or
- the correlation values (K2) derived from the second magnetic signal (M2), as a function of the longitudinal direction (y) of the security element, are correlated with at least one predetermined reference pattern (R2, R2') as a function of the longitudinal direction (y) of the security element, and the result of this further correlation is employed for checking the security element.

9. The method according to any of the preceding claims, **characterized in that** a magnetic region whose first magnetic signal (M1) or values derived therefrom, in particular correlation values (K1), exceed a first upper threshold (O1) and/or undershoot a first lower threshold (U1), and whose second magnetic signal (M2) or values derived therefrom, in particular correlation values (K2), neither exceed a second upper threshold (O2) nor undershoot a second lower threshold (U2), is identified as a combined magnetic region (k).

10. The method according to any of the preceding claims, **characterized in that** a magnetic region whose first magnetic signal (M1) or values (K1) derived therefrom, in particular correlation values (K1), neither exceed a first upper threshold (O1) nor undershoot a first lower threshold (U1), and whose second magnetic signal (M2) or values (K2) derived therefrom, in particular correlation values (K2), exceed a second upper threshold (O2) and/or undershoot a second lower threshold (U2), is identified as a soft-magnetic magnetic region (w).

11. An apparatus for checking a value document (1) which can have a security element (2) having high-coercivity magnetic material of a first coercive field strength and having low-coercivity magnetic material of a second coercive field strength, wherein the apparatus comprises one after the other along a transport direction (T) of the value document:
- a first magnetization device (3, 4, 20) for making available a first magnetic field (A) which is configured for effecting first magnetizing of the high-coercivity and of the low-coercivity magnetic material in a first magnetization direction, wherein the magnetic field strength employed for the first magnetizing is greater than the first coercive field strength, and thereafter
- a first magnetic detector (12) for detecting first magnetic signals (M1) of the security element (2), and thereafter
- a second magnetization device (8) for making available a second magnetic field (B) which is configured for effecting second magnetizing of the low-coercivity magnetic material in a second magnetization direction which is oriented anti-parallel to the first magnetization direction, wherein the magnetic field strength employed for the second magnetizing is smaller than the first coercive field strength, but is greater than the second coercive field strength, and a second magnetic detector (14) for detecting second magnetic signals (M2) of the security element (2),
**characterized in that** the second magnetic field (B) is configured such that the second magnetic signals (M2) of the security element are detected under the action of the second magnetic field (B), wherein the respective magnetic region whose second magnetic signal is detected, is located, during the detection of its second magnetic signals, in the second magnetic field whose magnetic field strength is smaller than the first coercive field strength, but greater than the second coercive field strength.

12. The apparatus according to claim 11, **characterized in that** the second magnetization device has one or several magnets (8) disposed on one side of the transport path (S) of the value document, being disposed on that side of the transport path (S) on which the second magnetic detector (14) is also disposed.

13. The apparatus according to either of claims 11 to 12, **characterized in that** the at least one magnet (8) of the second magnetization device and the second magnetic detector (14) are mechanically fixed to each other so as to form one constructional unit.

14. The apparatus according to any of claims 11 to 13, **characterized in that** the second magnetic detector (14) is disposed on the at least one magnet (8) such that the distance between the surface of the at least one magnet (8) and the magnetosensitive elements (15) of the second magnetic detector (14), along the direction perpendicular to the transport plane of the value document, amounts to at most 4 mm.

15. The apparatus according to any of claims 11 to 14, **characterized in that** the first magnetization direction is oriented parallel or anti-parallel to the transport direction (T) of the value document (1).

## Revendications

1. Procédé vérification d'un document de valeur (1) comportant un élément de sécurité (2) ayant plusieurs zones magnétiques (h, 1, k, w), cependant que les plusieurs zones magnétiques de l'élément de sécurité comportent au moins une zone magnétique hautement coercitive (h) qui contient un matériau magnétique hautement coercitif ayant une première intensité de champ coercitif, et éventuellement au moins une zone magnétique faiblement coercitive (1) qui contient un matériau magnétique faiblement coercitif ayant une deuxième intensité de champ coercitif inférieure à la première intensité de champ coercitif, et/ou au moins une zone magnétique combinée (k) qui contient tant le matériau magnétique hautement coercitif que le matériau magnétique faiblement coercitif, cependant que, dans le procédé, les étapes suivantes sont exécutées :
- première magnétisation de l'élément de sécurité (2) par un premier champ magnétique (A) dont l'intensité de champ magnétique est supérieure à la première intensité de champ coercitif, de telle sorte que la magnétisation du matériau magnétique hautement coercitif et la magnétisation du matériau magnétique faiblement coercitif sont alignées dans une première direction de magnétisation, et ensuite
- détection de premiers signaux magnétiques (M1) de l'élément de sécurité (2) par un premier capteur magnétique (12), et ensuite
- deuxième magnétisation de l'élément de sécurité (2) par un deuxième champ magnétique (B) dont l'intensité de champ magnétique est inférieure à la première intensité de champ coercitif mais supérieure à la deuxième intensité de champ coercitif, cependant que le deuxième champ magnétique (B) est orienté de telle façon que la magnétisation du matériau magnétique faiblement coercitif par la deuxième magnétisation est alignée de façon antiparallèle à la première direction de magnétisation, et détection de deuxièmes signaux magnétiques (M2) de l'élément de sécurité (2) par un deuxième capteur magnétique (14), **caractérisé en ce que** les deuxièmes signaux magnétiques (M2) de l'élément de sécurité sont détectés sous l'effet du deuxième champ magnétique (B), cependant que la zone magnétique respective dont le deuxième signal magnétique est détecté se trouve, pendant la détection de ses deuxièmes signaux magnétiques, dans le deuxième champ magnétique dont l'intensité de champ magnétique est inférieure à la première intensité de champ coercitif mais supérieure à la deuxième intensité de champ coercitif.

2. Procédé selon la revendication 1, **caractérisé en ce que** la au moins une zone magnétique combinée (k) est magnétisée de telle façon par le deuxième champ magnétique (B) qu'une magnétisation résultante de la au moins une zone magnétique combinée (k) découlant de la deuxième magnétisation disparaît au moins approximativement.

3. Procédé selon une des revendications précédentes, **caractérisé en ce que**, par le deuxième capteur magnétique (14), aussi des deuxièmes signaux magnétiques (M2) d'une ou de plusieurs zones magnétiques douces (11, w) du document de valeur (1) sont détectés.

4. Procédé selon une des revendications précédentes, **caractérisé en ce que** tant le matériau magnétique hautement coercitif que le matériau magnétique faiblement coercitif de l'élément de sécurité sont magnétisés dans la première direction de magnétisation juste avant et pendant la détection des premiers signaux magnétiques (M1) de la zone magnétique respective.

5. Procédé selon une des revendications précédentes, **caractérisé en ce qu'**une évaluation des signaux magnétiques de l'élément de sécurité est effectuée, lors de laquelle
- pour plusieurs zones magnétiques (h, l, k, w) de l'élément de sécurité, respectivement individuellement au moins une valeur de corrélation (K1) déduite du premier signal magnétique (M1) de la zone magnétique respective est utilisée, laquelle est constituée par une corrélation entre le premier signal magnétique (M1) respectif et un premier signal de base (B1) caractéristique du premier capteur magnétique (12), et/ou
- pour plusieurs zones magnétiques (h, l, k, w) de l'élément de sécurité, respectivement individuellement au moins une valeur de corrélation (K2) déduite du deuxième signal magnétique (M2) de la zone magnétique respective est utilisée, laquelle est constituée par une corrélation entre le deuxième signal magnétique (M2) respectif et un deuxième signal de base (B2) caractéristique du deuxième capteur magnétique (14).

6. Procédé selon la revendication 5, **caractérisé en ce que** le premier et/ou le deuxième signal de base (B1, B2) est choisi en fonction des propriétés de l'élément de sécurité ou de la zone magnétique respective, en particulier en fonction de l'étendue de l'élément de sécurité (2) ou de la zone magnétique respective le long d'une direction de transport du document de valeur.

7. Procédé selon la revendication 5 ou 6, **caractérisé en ce que** le premier signal de base (B1) est déterminé dynamiquement à partir du premier signal magnétique (M1) et/ou le deuxième signal de base (B 1) à partir du deuxième signal magnétique (M2) d'une ou de plusieurs zones zones magnétiques (h, l, k, w) de l'élément de sécurité, cependant que le premier et/ou le deuxième signal de base (B1, B2) est de préférence déterminé individuellement pour chaque élément de sécurité.

8. Procédé selon une des revendications de 5 à 7, **caractérisé en ce qu'**une évaluation est effectuée, lors de laquelle
- les valeurs de corrélation (K1) déduites du premier signal magnétique (M1) sont, en tant que fonction de la direction longitudinale (y) de l'élément de sécurité, mises en corrélation avec au moins une courbe prédéterminée de référence (R1, R1') en tant que fonction de la direction longitudinale (y) de l'élément de sécurité, et le résultat de cette corrélation subséquente est utilisé pour la vérification de l'élément de sécurité, et/ou
- les valeurs de corrélation (K2) déduites du deuxième signal magnétique (M2) sont, en tant que fonction de la direction longitudinale (y) de l'élément de sécurité, mises en corrélation avec au moins une courbe prédéterminée de référence (R2, R2') en tant que fonction de la direction longitudinale (y) de l'élément de sécurité, et le résultat de cette corrélation subséquente est utilisé pour la vérification de l'élément de sécurité.

9. Procédé selon une des revendications précédentes, **caractérisé en ce qu'**une zone magnétique magnétique dont le premier signal magnétique (M1) ou des valeurs en étant déduites, en particulier des valeurs de corrélation (K1), dépassent un premier seuil supérieur (O1) et/ou sous-dépassent un premier seuil inférieur (U1) et dont le deuxième signal magnétique (M2) ou des valeurs en étant déduites, en particulier des valeurs de corrélation (K2), ne dépassent pas un deuxième seuil supérieur (O2) et/ou ne sous-dépassent pas non plus un deuxième seuil inférieur (U2), est identifiée comme zone magnétique combinée (k).

10. Procédé selon une des revendications précédentes, **caractérisé en ce qu'**une zone magnétique dont le premier signal magnétique (M1) ou des valeurs (K1) en étant déduites, en particulier des valeurs de corrélation (K1), ne dépassent pas un premier seuil supérieur (O1) et ne sous-dépassent pas non plus un premier seuil inférieur (U1) et dont le deuxième signal magnétique (M2) ou des valeurs (K2) en étant déduites, en particulier des valeurs de corrélation (K2), dépassent un deuxième seuil supérieur (O2) et/ou sous-dépassent un deuxième seuil inférieur (U2), est identifiée comme zone magnétique douce (w).

11. Dispositif de vérification d'un document de valeur (1) pouvant comporter un élément de sécurité (2) ayant du matériau magnétique hautement coercitif d'une première intensité de champ coercitif et du matériau magnétique faiblement coercitif d'une deuxième intensité de champ coercitif, cependant que le dispositif comprend les uns après les autres le long d'une direction de transport (T) du document de valeur :
- un premier équipement de magnétisation (3, 4, 20) pour la mise à disposition d'un premier champ magnétique (A) conçu pour la première magnétisation du matériau magnétique hautement coercitif et du matériau magnétique faiblement coercitif dans une première direction de magnétisation, cependant que l'intensité de champ magnétique utilisée pour la première magnétisation est supérieure à la première intensité de champ coercitif, et ensuite
- un premier détecteur magnétique (12) pour la détection de premiers signaux magnétiques (M1) de l'élément de sécurité (2), et ensuite
- un deuxième équipement de magnétisation (8) pour la mise à disposition d'un deuxième champ magnétique (B) conçu pour la deuxième magnétisation du matériau magnétique faiblement coercitif dans une deuxième direction de magnétisation qui est orientée de façon antiparallèle à la première direction de magnétisation, cependant que l'intensité de champ magnétique utilisée pour la deuxième magnétisation est inférieure à la première intensité de champ coercitif mais supérieure à la deuxième intensité de champ coercitif, et un deuxième détecteur magnétique (14) pour la détection de deuxièmes signaux magnétiques (M2) de l'élément de sécurité (2),
**caractérisé en ce que**
le deuxième champ magnétique (B) est conçu de telle manière que les deuxièmes signaux magnétiques (M2) de l'élément de sécurité sont détectés sous l'effet du deuxième champ magnétique (B), cependant que la zone magnétique respective dont le deuxième signal magnétique est détecté se trouve, pendant la détection de ses deuxièmes signaux magnétiques, dans le deuxième champ magnétique dont l'intensité de champ magnétique est inférieure à la première intensité de champ coercitif mais supérieure à la deuxième intensité de champ coercitif.

12. Dispositif selon la revendication 11, **caractérisé en ce que** le deuxième équipement de magnétisation comporte un ou plusieurs aimants (8) agencés d'un côté de la voie de transport (S) du document de valeur, lequel/lesquels sont agencés du côté de la voie de transport (S) sur lequel le deuxième détecteur magnétique (14) est aussi agencé.

13. Dispositif selon une des revendications de 11 à 12, **caractérisé en ce que** le au moins un aimant (8) du deuxième équipement de magnétisation et le deuxième détecteur magnétique (14) sont fixés de telle façon mécaniquement l'un par rapport à l'autre qu'ils constituent une unité constructive.

14. Dispositif selon une des revendications de 11 à 13, **caractérisé en ce que** le deuxième détecteur magnétique (14) est agencé de telle façon sur le au moins un aimant (8) que l'écart entre la surface du moins un aimant (8) et les éléments magnéto-sensibles (15) du deuxième détecteur magnétique (14), le long de la direction perpendiculaire au plan de transport du document de valeur, est d'au maximum 4 mm.

15. Dispositif selon une des revendications de 11 à 14, **caractérisé en ce que** le premier équipement de magnétisation est orienté de façon parallèle ou antiparallèle à la direction de transport (T) du document de valeur (1).
